# EUROPEAN PATENT SPECIFICATION

(11) **EP 4 632 119 B1**
(45) Date of publication and mention of the grant of the patent: **09.12.2026**
(21) Application number: 25188106.6
(22) Date of filing: 19.01.2024
(51) Int. Cl.: C30B 11/00, C30B 29/40, C30B 29/42

(54) **DEVICE AND METHOD FOR MANUFACTURING AIII-BV - COMPOUND SEMICONDUCTOR SINGLE CRYSTALS**
VORRICHTUNG UND VERFAHREN ZUR HERSTELLUNG VON AIII-BV-VERBINDUNGSHALBLEITEREINKRISTALLEN
DISPOSITIF ET PROCÉDÉ DE FABRICATION DE MONOCRISTAUX SEMI-CONDUCTEURS DE COMPOSÉS AIII-BV

(30) Priority: 20.01.2023 DE 102023200457
(43) Date of publication of application: 15.10.2025
(62) Document number(s) of the earlier application(s) in accordance with Art. 76 EPC: 24701812.0 / 4 627 142
(73) Proprietor: Freiberger Compound Materials GmbH, 09599 Freiberg (DE)
(72) Inventor: EICHLER, Stefan, 01187 Dresden (DE); SUPTEL, Dmitry, 01187 Dresden (DE); SCHEFFER-CZYGAN, Max, 09116 Chemnitz (DE); LEIBIGER, Gunnar, 09599 Freiberg (DE); KRETZER, Ulrich, 09116 Chemnitz (DE); WEINERT, Berndt, 09599 Freiberg (DE); MILEK, Theodor, 09599 Freiberg (DE); DIETRICH, Marc, 09603 Großschirma (DE)
(74) Representative: Prüfer & Partner mbB Patentanwälte · Rechtsanwälte

(56) References cited:
- WO-A1-2020/245215
- JP-A- H09 315 881
- US-A1- 2021 269 939
- US-A1- 2022 298 673
- MÜLLER G. ET AL: "Types and origin of dislocations in large GaAs and InP bulk crystals with very low dislocation densities", PHYSICA STATUS SOLIDI. A: APPLICATIONS AND MATERIALS SCIENCE, vol. 202, no. 15, 17 December 2005 (2005-12-17), DE, pages 2870 - 2879, XP093142423, ISSN: 1862-6300, DOI: 10.1002/pssa.200521179

## Description

### Technical Field:

The invention relates to a device and a method for manufacturing AIII-BV compound semiconductor single crystals.

### Technical Background:

Such single crystals as considered herein are usually produced by solidifying a melt comprising the semiconductor material in a crucible using a seed crystal made of the same semiconductor material as the semiconductor single crystal to be produced. The crucible is generally cylindrical in shape having a central axis and a diameter which, taking into account a slight oversize which is removed by extensive material removal in a process following solidification, essentially corresponds to the nominal diameter of the AIII-BV compound semiconductor wafers to be produced. A narrow seed channel, which can also be arranged off-center, is located at the lower end of the crucible in the vertical direction. During operation, a temperature field generated by suitably arranged and controlled heating elements and aligned parallel to the central axis extends from this channel. A crystallization front or phase boundary substantially perpendicular to the central axis moves vertically upwards from the seed crystal.

Gallium arsenide or indium phosphide substrate wafers are particularly, but not exclusively, suitable for manufacturing light-emitting components such as micro LEDs or vertical cavity surface emitting lasers (VCSEL) or high-frequency transistors (pHEMT, HBT, DHBT, BiHEMT). Their operating characteristics and performance capabilities can be significantly influenced or impaired by the physical properties of the substrate and its surface. It is thereby important that the properties are distributed as homogeneously as possible across the surface of the substrate or wafer so that all optical or electronic devices manufactured from the wafer are subject to the same, uniform and preferably high-quality requirements.

The physical properties or variables mentioned include, among others, mechanical residual stress or strain, flatness, roughness, particle density, specific electrical resistance, or dislocation density, etc. Some of these variables, in particular dislocations, specific electrical resistance or residual mechanical stresses, are subject to greater deviations, especially at the edge of the wafer. This is caused, among others, by thermal stress which occurs during cooling of the crystal after solidification, and which particularly occurs at a crucible wall or at and near a surface of the adjacent single crystal.

As a result, in order to ensure a high degree of homogeneity of the properties, there is generally defined an edge exclusion, which denotes a ring-shaped area on the wafer surface (or a section shaped as a cylinder shell within a single crystal or boule that is not yet separated into wafers), which is not to be employed by the device manufacturer for the actual production of devices, while the central area of the wafer which is used for the production of devices, and which complements the edge exclusion, regularly reveals excellent homogeneity values.

Values for the edge exclusion known in the patent literature may range between 2.5 mm and 5 mm depending on the diameter and material (GaAs or InP), for example (see e.g. US 2021/310155 A1, EP 3514266 A1, US 2019/371620 A1, EP 1634981 B1, EP 3591102 A1, US 10,473,445 B2, EP 3862134 A1, EP 2458041 B1). As one example, the usable area available for the manufacturing of devices for a GaAs wafer with a diameter of 150 mm and edge exclusion of 3 mm amounts to approximately 169.7 cm², with a total wafer area of 176.7 cm². The edge exclusion therefore results in a relative loss of non-usable area of around 4%. In the case of an InP wafer with a diameter of currently up to 100 mm, a common edge exclusion may also range at 3 mm. The usable area available for the manufacturing of devices in this case amounts to 73.9 cm², with a total wafer area of 78.5 cm². In this case, the edge exclusion results in a relative loss of non-usable area of around 6%. This implies that a relative loss of area will decrease with advancing technology (i.e., with a larger diameter). Nevertheless, applying a constant amount of edge exclusion, the loss of non-usable area in absolute terms will still increase linearly with the increasing diameter.

There is therefore a need to reduce the loss of AIII-BV composite semiconductor material during device manufacture - both for reasons of economy and sustainability. A key starting point for this is to improve the quality and homogeneity of the physical parameters mentioned (residual stress, specific electrical resistance), particularly in the edge area, so that, for example, the respectively specified value for an edge exclusion may be reduced.

Thermal stress in an edge area of a single crystal may be caused in particular by a curvature of the temperature field or a phase boundary deflection during crystallization. The Vertical Bridgeman (VB) or Vertical Gradient Freeze (VGF) process or thermally analogous processes are regularly selected as preferred growth methods due to a relatively low curvature of a respective temperature field which is involved hereby. (see for example M. Jurisch et al. in "Handbook of Crystal Growth Bulk Crystal Growth: Basic Techniques" VOLUME II, Part A, Second Edition, Chapter 9 "Vertical Bridgman Growth of Binary Compound Semiconductors", 2015*).*

According to experimental and theoretical studies, the amount and distribution of dislocation density are mainly determined by lattice relaxation processes during plastic deformation due to thermal stresses caused by large thermal gradients (see e.g: J. Yang, W. Lu, M. Duan, H. Xie, G. Shen, J. Liu, Z. Dong, Y. Zhao, "VGF growth of high quality InAs single crystals with low dislocation density", Journal of Crystal Growth 531 (2020) 125350; J. Völkl, "Stress in the cooling crystal", in: D.T.J Hurle (Ed.), Handbook of Crystal Growth, Elsevier Science B, 1994, P. 821; P. Rudolph, M. Jurisch, Crystal Growth Technology, John Wiley & Sons, Ltd, 1994, p. 800). Accordingly, dislocations may occur herein if the thermal stress exceeds a critical value of the shear stress regarding lattice slip. With regard to such critical value, the thermal gradient and the deviation of the isotherms from linear planes or the extent of the phase boundary deflection play an important role (see e.g: N.A. Anastaskeva, V.T. Bublik, V.V. Karatsev, et al., Sov. Phys. Crystallogr. 34 (1989) 912).

In order to enable crystal growth from the melt, the presence of temperature gradients in the crystal is an essential prerequisite. The single crystal hereby serves as a heat transport medium through which heat, namely the heat of fusion released in each case and also the heat contained in the melt due to initial heating, is transferred to the environment via the crucible wall. In particular, heat enters the crystal at the interface between the single crystal and the melt and leaves it via the outer surfaces by radiation and convection. Consequently, the interior of the single crystal is hotter than its edge, and an end of the single crystal close to the seed channel is cooler than material close to the phase boundary. Accordingly, the resulting temperature gradients lead to thermal stress and strain in the various sections of the single crystal, which may ultimately cause plastic deformation due to the movement of dislocations which have already formed (see, e.g.: Vishwanath Prasad, Srinivas Pendurti. "Part F Modeling in Crystal Growth and Defects. 39 Models for Stress and Dislocation Generation in Melt Based Compound Crystal Growth" in "Springer Handbook of Crystal Growth" G. Dhanaraj, K. Byrappa, V. Prasad, M. Dudley (Eds.), Springer-Verlag, Berlin - Heidelberg (2010) p. 1349).

In document US 2020/066850 A1, concrete amounts are provided for a residual strain content in an area at least close to the edge of conventionally grown InP wafers with diameters of 100 mm to 205 mm. An area close to the edge was investigated, which extends from a flat or a notch of 2 mm to the inside of the wafer surface. The substrates had thicknesses of 300 to 800 µm and contained impurity atoms in abundances of 2.0 to 8.0×10¹⁸ cm⁻³ (sulphur), 1.0 to 4.0×10¹⁸ cm⁻³ (tin) or 5.0×10¹⁵ to 1.0×10¹⁷ cm⁻³ (iron). A mean value of residual strain in the edge area defined in this way was 5×10⁻⁶ to 5×10⁻⁵.

In document EP 3 835 465 A1, a residual strain content was determined in a near-edge region of C-doped, semi-insulating GaAs wafers, which in the embodiment shown had a diameter of 152.4 mm and a thickness of 700 µm. The near-edge region was characterized herein by an annular section symmetrical to the wafer center, having a width of 5 mm and a distance to the wafer edge of also 5 mm (i.e., a depth of 5 mm to 10 mm seen from the edge). Residual stress has been measured for various wafers as a function of a temperature difference that occurs after the growth process (VB process) during cooling between one end of the seed channel and an opposite end of the 200 mm long single crystal (not yet separated into wafers), whereby the temperature difference could ultimately be controlled via heating elements. This temperature difference may also be representative of radial temperature gradients at the outer edge of the single crystal. It was found that those samples with the lowest set temperature difference (i.e. 2 °C) show average values of a distribution of residual strain in the defined near-edge region of 3.5×10⁻⁶ (separated wafers corresponding to a position in the crucible near the seed channel) to 1.2×10⁻⁵ (separated wafers corresponding to a position in the crucible near the end that crystallized at last). Sliding and thus comparatively high values for dislocation densities were only recorded for samples with a high temperature difference (i.e. 20 °C).

Herein, it should be noted that a distinction must be made between dislocations which, for example, continue from the seed channel in the direction of the advancing crystallization front during crystal growth and exhibit a more or less free or "cloud-like" distribution in cross-sectional planes, and dislocations in so-called slip lines, which result from thermal stress at the edge during cooling of the solidified crystal.

Consequently, it may be desirable to determine the deflection of the phase boundary by the cooling rate to which the crystal is subjected. During crystal growth, the cooling rate should be adjusted starting from the melting point down to room temperature so that the resulting thermal stresses are below the critical shear stress for dislocation multiplication and sliding. The cooling rate also determines the generally concave shape of the phase boundary with increasing curvature towards the crucible wall, which is an expression of the shape of the isotherms and thus the non-linearity of the temperature field. As described, a nonlinear temperature field leads to a curved phase boundary shape, to thermal stress in the growing crystal, to dislocations arranged in slip lines if the thermal stress is too high, to dislocation multiplication at high thermal stress and to residual stress in the crystal at room temperature (see Manfred Jurisch, Stefan Eichler, Martin Bruder, "9 - Vertical Bridgman Growth of Binary Compound Semiconductors", Ed. Peter Rudolph, In Handbook of Crystal Growth, Handbook of Crystal Growth (Second Edition), Elsevier, 2015, Pages 331-372, ISBN 9780444633033, https://doi.org/10.1016/B978-0-444-63303-3.00009-2.

The slip lines are created by an intersection of dislocation loops, which extend in a slip plane and are emitted by a Frank-Read source and are collinear to each other, with a cross-sectional surface, which may be the planar surface of a separated wafer. In a single crystal, the slip planes form the planes between the atomic layers with the densest packing and large layer spacing. In the case of the AIII-BV compound semiconductors considered herein, these may regularly be {111} lattice planes, particularly at the critical crystal edge. The individual dislocation loops lead to an intersection point within a respectively cut cross-sectional surface, and due to the collinearity within the slip plane, these intersection points lie on a line, which is referred to as a slip line. Depending on the mechanical stress and specific thermal load, the dislocation loops may expand or contract back towards the Frank-Read source. In this case, however, the intersection pointss remain on the slip line, or move along it, respectively.

Morphologically, the slip lines may hardly exert any influence on the flatness or roughness of a surface of a raw wafer. However, during epitaxy carried out for subsequent device fabrication, unwanted macroscopic steps may form upon the surface at these slip lines (Sawada, S.; Yoshida, H; Kiyama, M.; Mukai, H.; Nakai, R.; Takebe, T.; Tatsumi, M.; Kaji, M.; Fujita, K.: "Slip defect generation on GaAs wafers during high temperature process: a thermoelastic study from a crystallographic viewpoint" in GaAs IC Symposium IEEE Gallium Arsenide Integrated Circuit Symposium. 18th Annual Technical Digest 1996 (1996): 50-53.

It is therefore desirable to either assign the dislocations made detectable in a known manner by etch pit formation in the cross-sectional surface (wafer surface) to a slip line or alternatively to classify them as free dislocations in order to enable quantification of the slip lines in the edge area of the wafer with regard to the undesired step formation.

The standard SEMI M10 - Terminology for Identification of Structures and Features Seen on Gallium Arsenide Wafers (available via semi.org: https://store-us.semi.org/products/m01000-semi-m10-terminology-for-identification-of-structures- and-features-seen-on-gallium-arsenide-wafers) provides a definition in this regard: "... *Slip is evidenced by a pattern of one ore more straight lines of 10 or more dislocations per millimetre which do not necessarily touch each other".* This implies an average mutual spacing of the dislocations within a slip line of about 100 µm. Unfortunately, this definition is not useful for the substrates with low dislocation density (EPD; etch pit density) discussed in this application, because the average spacing may in practice amount up to 500 µm. Furthermore, the actual slip lines (or the arrangement of the associated intersections in the cross-sectional surface) may deviate from exactly straight lines due to interactions with point defects and other dislocations.

For the purposes of substrates having a low dislocation density, a slip line is therefore identified or detected as such by measurement in the present specification, if:
- more than 10 etch pits representing dislocations extend along one direction in the cross-sectional surface;
- these dislocations form a chain with a maximum distance of 500 µm for each neighboring etch pit;
- the etch pits lie perpendicular to the direction within a 250 µm wide tolerance interval; and
- the slip line extends from a point within an annular edge area of the cross section or planar cross-sectional surface, respectively, the width of the edge region being defined by a distance of 5 mm measured from the outer edge of the single crystal or wafer with an edge exclusion of 2 mm.

This definition makes it possible to detect and quantify slip lines close to the edge.

However, there is still the problem that no devices may be produced on the wafer in the area of the wafer edge up to 3 mm into the crystal (or towards its center axis), as the residual stress and the dislocation density in the edge area are too high or are not known. The devices are built up in epitaxial layers that are grown on the wafer. Residual stress at the edge of the wafer above a limit value may lead to stressed epitaxial layers and thus different properties of the components or devices originating from the edge of the wafer as compared with those originating from a central region of the wafer. In particular, slip under the influence of thermally induced stress may lead to locally greatly increased dislocation densities, which can be several times the average dislocation density of the entire wafer. The correlation described above between a phase boundary deflection and the crystal quality in the edge region of the wafer makes it clear that an improvement in the crystal growth and cooling process is desirable. In particular, it is an object of embodiments of the present invention to reduce thermal stress, to limit the associated dislocations and to improve the crystal structure. Furthermore, it is an object to provide AIII-BV compound semiconductor single crystals and wafers produced by separation therefrom, in which costly material losses due to areas which cannot be used for subsequent component or device production are restricted.

Document JP H09-315881 A discloses a production method of a crystal in which the generation of crystal defects is reduced. The corresponding device intended for a vertical Bridgman method is provided with a crucible for receiving a raw material, a stage for supporting the crucible, a lower shaft for supporting the stage and a vertical temperature gradient furnace. In this device a cooling pipe, through the inside of which a cooling medium is passed, is wound around an outer surface of the lower shaft supporting the stage, wherein air or water is used as the cooling medium. Further, the outer surface of the lower shaft is covered with pyrolytic boron nitride (pBN) that is a material having low heat emissivity, or a cylinder made of alumina that is also a material having low heat emissivity is placed on the outer periphery of the outer surface of the lower shaft.

### Summary of the Invention:

The object is solved by a device for manufacturing an AIII-BV - compound semiconductor singe crystal from a melt of a raw material as defined in appended claim 1 and by a method of manufacturing a AIII-BV-compound semiconductor single crystal from a melt of a raw material as defined in appended claim 17. Advanatgeous embodiments are defined in the dependent claims.

Such device comprises a crucible for receiving a melt, wherein the crucible has a central axis and a crucible wall having a shell-shaped outer face, which faces away from the central axis in a direction radially outwards, and a component substantially surrounding the crucible and opposing the crucible wall in a distance by an inner face facing the outer face, wherein the crucible wall is provided in a relationship with the component surrounding the crucible that is subtantially a thermal radiation exchange.

The outer face of the crucible wall has first emissivity and the inner face of the opposite component surrounding the Crucible has a second emissivity. The first emissivity and second emissivity each indicate how much radiation is emitted from the crucible wall and the component surrounding the crucible, respectively, as compared with an ideal radiant heater (i.e., a ratio of the thermal radiation from the face to the radiation from an ideal black surface at the same temperature as given by the Stefan-Boltzmann law).

The outer face of the crucible and/or the inner face of the component surrounding the crucible are at least partially provided by a coating which defines the first and second emissivity, respectively, such that the first emissivity and/or the second emissivity each amount to a value of 0.1 or less.

The invention is based on the perception that a homogeneity of the crystal properties in the direction of wafer cutting, or perpendicular to the central axis of the single crystal from which the wafers are separated, is essentially affected by a curvature of the phase boundary between the grown crystal and the melt. Here, increased thermal stress may occur (accompanied by a curvature of the temperature field) and the dislocation density may increase locally. In addition, incorporation of dopants in the crytal lattice may generally occur at constant concentration along the curved phase boundaries, i.e., inhomogeneous dopant distributions and electrical properties result on a straightly (planar) cut wafer. The curvature of the phase boundary becomes particularly prominent at the edge of the crystal in the vicinity of crucible wall, as a consequence of transport of latent heat (GaAs: 668,5 J/g, InP: 429,5 J/g) developing at the crystallization front, due to a relatively large radial component of heat transport. The transport of heat is determined on the one hand by the relatively high thermal conductivity of the crucible or the crucible wall (0.8 W/cmK) compared to the solidifying crystal (GaAs: 0.0712 W/cmK, InP: 0.0911 W/cmK). On the other hand, the transport of heat due to radiation at the growth temperatures of GaAs and InP Becomes very efficient and the radiation of latent heat oriented in a radial direction through the crucible may be considerable. At least the latter circumstance is addressed by the above stated aspect of the present invention.

In particular, the radially directed heat radiation is adjusted by at least partially providing a coating having a relatively low emissivity ε to faces which limit a radiation space outside the crucible. This may apply to just one or both of the limiting faces. The radiation space outside the crucible may substantially have a shape of a cylinder shell. An inner surface limiting the radiation space may generally provided by the crucible wall or its face which is facing outwards, respectively. The crucible itself also includes a cylinder shape, however, according to aspects of the invention, deviations from a cylinder shape are also encompassed. More specifically, crucibles having geometric are body shapes with quadrangular, pentagonal, hexagonal or polygonal base areas may also be conceivable, or cylinders having laterally flattened segment faces are possible as well.

The outer surface limiting the radiation space is an inner face of crucible surroundings which face the outer face of the crucible wall. Various components may be embodied hereby, depending on the construction of the growth or manufacturing device. Most commonly, the crucible surroundings providing the inner face will be represented by a component surrounding the crucible more or less almost all around, including one or more parts jointly forming the functional component. Only beyond such component (as seen from the central axis of the Crucible) There may be arranged one or more heating elements, which are used to initially melt the raw material and afterwards are controlled to adjust or set a suitable temperature gradient within the crucible.

The radiant power P of a gray body with the temperature T and the area A of a corresponding face may be specified according to the Stefan-Boltzmann law: $P = ε σ A {T}^{4}$ (1)

With the Stefan-Boltzmann-constant σ and the emissivity ε of the face. The emissivity is material-specific and may assume real values between 0 and 1. The net radiation balance M in a space between two approximately parallel faces, as is also the case with the device according to this aspect, whereby the distance is significantly smaller than the surface expansion of the inner face or the outer rface, may be calculated from: $M = \frac{1}{\frac{1}{{ε}_{1}} + \frac{1}{{ε}_{2}} - 1} σ \left({T}_{1}^{4}-{T}_{2}^{4}\right) = E σ \left({T}_{1}^{4}-{T}_{2}^{4}\right)$ (2)

A radation exchange degree E in equation (2) may thereby be represented as follows: $E = \frac{1}{\frac{1}{{ε}_{1}} + \frac{1}{{ε}_{2}} - 1}$ (3)

ε₁ or ε₂ therein denote the emissivities of the outer and inner faces, respectively. In the case of conventional devices, which are configured for AIII-BV-Compound semiconductor crystals according to the VGF- or VB-methods, ε₁ (outer face of crucible wall) amounts to about 0.5, whereas ε₂ (inner face of component surrounding crucible, for example a tube formed from graphite or as SiC) amounts to about 0.8. With regard to the resulting radiation exchange degree, value of E = 0.44 may be obtained as a mere example.

According to aspects of the invention, coatings are proposed on one side or on the other side, preferably on both sides of the radiation chamber, which significantly increase the emissivities, namely ε₁ ≤ 0,1 and/or ε₂ ≤ 0,1.

There are known in the art coatings and measures for adjusting the emissivity in a different context:
In US 2020/181796 A1 there is disclosed an arrangement for manufacturing SiC crystals by deposition from a gaseous phace. The graphite crucible contains the raw material to be vaporized at the bottom and the seed for crystal deposition at the top. A material with a low radiation rate (emissivity) is attached to the outside of the crucible in the upper area of the raw material. This is to ensure that the raw material at the top passes into the gas phase before the raw material below. As materials with a low radiation rate carbides, nitrides, Ta, Mo, Nb, Hf, W and Zr are mentioned.

JP 3 564 740 B2 discloses a device for growing crystals according to the Czochralski method. The emissivity of the inner wall of a steel boiler is increased in the upper area. As a result, the heat is intended to leave the grown crystal more quickly. This inevitably leads to a stronger bending of the phase boundary between solid and liquid in relation to the grown crystal.

JP 2014-162668 A discloses a device for manufacturing sapphire crystals. In the upper crucible region, the emissivity of the crucible is increased compared to the emissivity in the lower crucible region. This increases the heat exchange between the growing crystal and the environment.

JP H09-315881 A discloses a device for growing GaAs using the vertical Bridgman method. The shaft carrying the crucible is cooled in the lower region by a surrounding cooling coil. In the area above the cooling coil, the shaft is provided with pyrolitic boron nitride so that it has a lower emissivity and absorbs less heat from the environment. The emissivity of the outside of the crucible, on the other hand, is increased by a carbon coating.

In the present case, however, there is a basic idea not to locally increase or lower the emissivity (emissivities) or the radiation exchange degree, but to reduce these generally for the crucible as a whole, in considerable amounts, with the target to reduce the phase boundary deflection during and throughout crystal growth, i.e., over the whole length of the crystal.

Preferred embodiments provide in particular for an application to devices for growing or producing AIII-BV compound semiconductor crystals from a melt, which are operated according to Vertical Gradient Freeze (VGF) or Vertical Bridgman (VB) methods. Both processes are well known in the technical field: the raw material, which is usually still polycrystalline, is heated and melted in a crucible with a seed crystal at the bottom with the aid of one or more heating elements, e.g. a resistance heater, whereby the seed crystal is also slightly melted. A directed temperature field is set and/or adjusted in such a way that an essentially vertical gradient points from an upper area of the crucible towards the seed crystal in the seed channel at the bottom of the crucible. The temperature field is then shifted relative to the crucible. This can be done either by mechanically moving the crucible or the heating element(s) (VB method) or by changing the temperature field by means of targeted control of the heating elements of a corresponding heater (VGF method). The temperature field is moved in the opposite direction to the gradient so that the melt solidifies first in the lower area of the crucible, starting from the seed crystal, and crystal growth proceeds in a direction vertically upwards. The heated zone is slowly moved upwards so that the crystallization front also slowly moves upwards. The crystallization speed can be determined, among other things, by the speed at which the temperature field is shifted. The device may thus include the actual crucible with the cylindrical section as described above, for example, for holding the raw melt, the seed channel and a section that tapers between the cylindrical crucible and the narrower seed channel. Furthermore, it may include the heater with one or more heating elements, as well as a control unit which adjusts the temperature level and the temperature field depending on the selected method. According to the invention, the component surrounding the crucible is located between the crucible and the heating element(s) of the heater. The entire device may also comprise a housing on the outside which also accommodates the heater.

The reduced emissivity of the outer face of the crucible wall and/or the inner face of the component surrounding the crucible may lead to a considerably reduced thermal radiation. The heat conduction within the crucible wall is less affected by the measures according to the invention, but it is still present. Nevertheless, in the conventional case, thermal radiation may be extensive, such that due to the invention regions of the solidified crystal arranged radially outwards with respect to the central axis may release their thermal energy only with difficulty. This results in a significantly smaller radial component of the temperature gradient, or in other words: the temperature gradient is oriented more linearly parallel to the central axis of the crucible. As a consequence,Our, the phase boundary deflection is also reduced and the phase boundary itself becomes flatter up to the edge, or the crucible wall, respectively. also the phase boundary deflection is reduced and the phase boundary itself becomes more flat up to the edge. Hereby, it is accepted that heat transport has to be effected much more in an axial direction, which in turn extends the cooling time, or reduces the overall cooling rate. Nevertheless, such disadvantage is justified by an advantage of quality and yield improvement. If, however, the cooling rate should not be reduced, it is possible to adjust the heating power accordingly in such a manner, that the cooling rate is set as common in conventional devices.

For this purpose, according to specific embodiments, the crucible wall close to the seed channel (e.g., within the tapered section) or the (part of the) component of the surroundings opposing such section may remain uncoated, i.e., may include a conventional emissivity considerably larger than 0.1, in order to allow heat to be removed from the crucible. Furthermore, according to embodiments, the end face of the crucible opposite the seed channel and the face of the surrounding component facing that end face, if this is provided at this point, need not have a coating reducing the emissivity.

Coating here means a preferably thin, adherent layer. It can be applied in any way. This depends in particular on the material of the coating. It may also be a film fixed to the corresponding faces. The coating material is preferably temperature-stable and inert in the atmosphere in order to avoid contamination of the crystal.

According to a specific embodiment, the coating may be configured such that the emissivity amounts to 0,05 or less. This may apply to a coating on the side of the inner face of the component surrounding the crucible or a coating on the side of the outer face of the crucible wall, or both. Advantageously, also combinations of emissivity is of the coatings on both sides with values of ε₁ ≤ 0.1 and ε₂ ≤ 0.05 or vice versa ε₁ ≤ 0.05 and ε₂ ≤ 0.1 are possible. As described above, however, also the more simple cases and come past, in which just one coating having ε ≤ 0,05 Is applied only to one side of the radiation space.

One embodiment of the invention provides that the radiation exchange degree E calculated according to equation (3) amounts to 0.1 or less, preferably 0.05 or less in the radiation exchange between the crucible wall and the component surrounding the crucible.

As described, the specific embodiment of the device according to the invention provides that the outer face of the crucible wall and the inner face of the opposing component jointly form and restrict an intermediate space or radiation space having a shape of a cylinder shell, across which radiation exchange occurs during operation of the device.

According to a further embodiment, the coating forming at least part of the outer face and/or the inner face is designed as a periodic pattern, in particular a mosaic or stripelike pattern. More specifically, the emissivity may also be set via the area occupancy of the pattern.

According to a further embodiment, the coating at least partially forming the outer face and/or the inner face may be prepared shiny metallic. Due to such measure, a very low emissivity may be accomplished.

According to a further embodiment, the component surrounding the crucible is formed from hard graphite and has a rough metallic layer. By this, a desired and moderately low emissivity still according to the invention may be achieved. The rough metallic layer may for example be manufactured from platinum.

According to a further embodiment, the component surrounding the crucible is formed from hard graphite and has a shiny metallic layer. By this, a very low emissivity may be achieved. The shiny metallic layer may for example be manufactured from platinum. Alternatively, the hard graphite may be coated with boron nitride.

According to a further embodiment, the component surrounding the crucible is a quartz tube coated with graphite. In such a case, the component may be a so-called liner.

According to a further embodiment, the crucible may be manufactured from boron nitride or from pyrolytic boron nitride (pBN), wherein the outer face of the crucible wall is at least partially formed by a rough platinum or graphite coating. By this, a desired and moderately low emissivity still according to the invention can be achieved.

According to a further embodiment, the crucible may be manufactured from boron nitride or from pyrolytic boron nitride (pBN), wherein the outer face of the crucible wall is at least partially formed by a shiny platinum coating. By this in turn, a very low emissivity may be achieved.

According to embodiments the device may be configured to manufacture a AIII-BV-compound semiconductor single-crystal comprising GaAs or InP, preferably having nominal diameters of 100 mm, 150 mm or 200 mm. GaAs (gallium arsenide) or InP (indium phosphide) reveal defined melting temperatures and the control as well as the heating elements are coordinated with each other and configured to set the temperature level and to adjust the directed temperature field. With regard to the cited nominal diameters, the crucibles include an inner diameter, which is typically larger than the nominal diameter by 1 to 10 mm. Such oversize may account for material removal around the cylinder circumference In a post processing, which effects removal of particles originating from the Crucible at an outer edge of the crystal, Smoothing of the surface as well as optionally a removal (in case of large oversize) of and egde material having large dislocation densities.

The crucible wall may be made of a material with an internal structure such that the heat conduction is isotropic. This is by no means a matter of course. In the case of devices for growing GaAs or InP single crystals, the crucible walls are regularly made of pBN stacked in layers. The layering direction is perpendicular to the wall, i.e. the layers extend parallel to the central axis of the crucible. Heat transfer (heat conduction) is easier within the individual layers of the stack compared to heat conduction from layer to layer. Such a structure is usually used to minimize material loss in the crucible after each use of the crucible due to components firmly bonded to the crystal. The layered structure allows a loss of material quantifiable in advance and layer by layer and thus a prolonged service life for the crucible. However, the anisotropic heat conduction with respect to the direction of the crucible central axis means that heat is dissipated very efficiently from the edge of the grown crystal radially outwards. The proposed embodiment helps to limit this heat dissipation through heat conduction by using a material that is isotropic in this respect.

One embodiment provides for the crucible wall to be made of a material with an internal structure such that the thermal conductivity is 3 W/mK or less. For example, the crucible may be made of glassy carbon.

Another aspect of the present invention relates to a corresponding method for producing an AIII-BV compound semiconductor single crystal from the melt of a raw material. For this purpose, a device according to one of the above aspects or one of the above embodiments is provided first. The method further comprises the following steps:
- providing a seed crystal in a seed channel of the device;
- setting a directed temperature field parallel to the central axis of the crucible by means of one or more heating elements;
- setting a growth rate by controlling the heating element or elements in such a way that an angle of inclination between a phase boundary and a horizontal direction perpendicular to an inner surface of the crucible wall of 40 degrees or less, preferably 30 degrees or less, is continuously maintained;
- Solidification and further cooling of the single crystal.

In the step of setting the growth rate, preferably 37 degrees or less in case of GaAs as an AIII-BV-compound semiconductor or 34 degrees or less in case of InP as an AIII-BV- compound semiconductor, and more preferably 32 degrees or less in case of GaAs as an AIII-BV-compound semiconductor or 31 degrees or less in case of InP as an AIII-BV-compound semiconductor between a phase boundary and a horizontal direction perpendicular to an inner surface of an adjacent lateral crucible wall is continuously maintained.

The same advantages as described above may be achieved. The ideal target would be an inclination angle of 0°, which, however, may hardly be achieved in practice. The inclination angle or phase boundary deflection do generally not involve, at least in case of ranges of crystal diameters considered herein, a strong dependence from diameter. The deflection occurs particularly towards and close to the edge of the crystal, or close to the crucible wall. The inclination angle of 40 degrees or less approximately corresponds to a phase boundary deflection of 11 - 12 mm. The inclination angle of 30 degrees or less approximately corresponds to a phase boundary deflection of 4,5 - 5,0 mm. Both quantities, inclination angle and phase boundary deflection, may in practice hardly be determined or measured during the growth process, since there is almost no suitable sensor technology available adapted to the respective temperatures. Consequently, such parameters are determined in advance from simulation for the use of control of the heaters or the heating elements with respect to the concrete configuration. For this purpose, quite suitable simulation programs are available, which may indicate the phase boundary deflection, or the inclination angle dependent from the growth progress. According to the results of the calculation, the emissivities may be determined and implemented, and during operation the heating power may be configured and controlled, such that the inclination angle is may be achieved.

It is noted that AIII-BV-compound semiconductor single-crystals or particularly wafers obtained therefrom by separation and having characteristics as described below can be manufactured by a device and/or via a method as described above.

For example, an embodiment not forming part of the invention as defined in the appended claims relates to an AIII-BV-compound semiconductor single-crystal or particularly to a wafer obtained therefrom by separation, wherein within an annular edge area of a cross sectional area of the single crystal or wafer (in case of wafers, the cross sectional area is one of the two planar main surfaces) perpendicular to the central axis, a fraction of dislocation etch pits, which are associated with slip lines (slip dislocation lines), which extend starting from the edge area of the single crystal or wafer within the cross sectional area, amount to 30 % or less of a total number of dislocation etch pits, which are formed in the whole cross sectional area with the exception of an edge exclusion amounting to 2 mm measured from an outer edge of the single crystal or wafer.

A width of the edge area is given or measured by a distance of 5 mm from the outer edge of the single crystal or wafer. However, the edge exclusion of 2 mm is also defined or subtracted, so that the width of the annular edge area in the radial direction is 3 mm. The annular area is symmetrical in relation to the central axis of the single crystal or wafer. The edge exclusion extends directly from the outer edge and takes into account the areas that are no longer metrologically accessible for reliable detection of physical quantities due to the usual edge rounding of the wafer in question and the areas adjacent to it.

As described above, the problem occurring at an edge of a manufactured single crystal or wafer is that thermal stress is generated during the cooling process, which may have an effect of creating slip lines, e.g. starting from Frank-Read sources, especially in the edge area. Absolute numbers of dislocation etch pits, which are associated with these slip lines, are related to the quality of the manufacturing process of the singly crystal or wafer particularly with regard to the cooling process.. Such dislocation etch pits must be distinguished from those assocaited with the dislocations that advance from the seed channel during the growth process, for example, and which may be more or less freely distributed.

The specified parameter thus describes the quality of the measures affecting the peripheral area in particular, as described in the previous aspects. In case of a single crystal or wafer, which includes a comparatively low fraction of dislocation etch pits being arranged in slip lines (slip dislocation lines), which in particular geometrically originate in an edge area as specified above, the quality (EPD) of the edge area is closer to the corresponding quality of an inner area of the cross-sectional area (i.e., an area within a circle defined by the inner boundary line of the edge area facing the central axis). In other words, if an inner region of such a wafer (after separation) fulfils the requirements for a subsequent manufacture of devices, then such situation also extends to surface regions within the etch area, if values of the specified parameter are sufficiently low - the fraction of area that can be utilised for device manufacture may thus be increased.

In particular, however, the fraction of dislocation etch pits achieved here, which belong to slip lines (denoted herein as slip dislocation lines) extending in the cross-sectional area starting or originating from the edge area of the single crystal or the wafer, may advantageously avoid or at least considerably reduce the formation of morphologically macroscopic steps in the wafer surface in epitaxy steps following manufacture. It should be noted that the present low values of the parameter can be achieved in particular by the device described above.

According to a specific embodiment of the AIII-BV-compound semiconductor single-crystal or wafer not forming part of the invention as defined in the appended claims, the fraction of dislocation etch pits belonging to slip lines extending from the edge region of the single crystal or the wafer in the cross-sectional area with regard to the total number of dislocation etch pits may amount to less than 10 %, further preferably less than 5 %. The fraction determined in this way may also be referred to herein as the "slip degree".

To determine the fraction, etch pits are first generated in a surface (cross-sectional area) of a separated wafer at those positions where a dislocation intersects the surface. This can be done in a usual way, e.g. by immersing the surface in molten KOH. The resulting etch pits render the dislocations detectable. With a lateral resolution of, e.g., 3.7 µm, all etch pits on the surface may then be recorded using a scanning optical microscope with camera and image processing and stored with position information (XY coordinates etc.), e.g. in a table.

There may well be tens of thousands of etch pits on an 8" wafer. An assignment to slip lines is then checked for all etch pits on this database, whereby the following requirements must be met for the existence of and assignment to the slip lines as described above:
- etch pits representing more than 10 dislocations extend along one direction in the cross-sectional surface;
- these dislocations form a chain with a maximum distance of 500 µm for each neighboring etch pit;
- the etch pits lie within a 250 µm wide tolerance interval perpendicular to the direction; and
- the slip line extends from a point within an annular edge area of the cross-sectional surface, wherein an edge area is defined close to the outer edge of the surface, the boundary of which, directed towards the center of the surface, is defined by a distance of 5 mm measured from the outer edge of the single crystal or wafer with an edge exclusion of 2 mm.

A corresponding algorithm may provide for searching for the nearest neighbors to a considered position of an etch pit and contniuously checking the above-mentioned conditions. Finally, the dislocation etch pits assigned to the slip lines are divided by the total number of all dislocation etch pits.

According to a further embodiment of the above mentioned AIII-BV compound semiconductor single crystal or wafer produced therefrom by separation, a relative frequency of slip lines, which extend within the cross sectional area starting or originating from the edge area of the single crystal or wafer, with respect to a circumference length of the cross-sectional area of the single crystal or wafer amounts to 0.25 cm⁻¹ or less, in particular 0.20 cm⁻¹ or less.

In this embodiment, that does not form part of the invention as defined in the appended claims, the number of slip lines related to the circumference of the single crystal or wafer (as determined above) is taken into account. This parameter also relates to the quality of the edge area to quantities of etch pits densities reduced by improved cooling. This quantity may also be referred to as "*slip dislocation line density*"*.* Preferred embodiments provide for, that such relative frequency may even amount to less then just 0.1 cm⁻¹ or less, more preferably 0.05 cm⁻¹ or less.

A further embodiment of the AIII-BV-compound semiconductor single-crystal or wafer not forming part of the invention as defined in the appended claims provides that a sum of the lengths of the slip lines (as determined above) is calculated and related to the diameter of the single crystal or wafer (i.e., the sum of the lengths is divided by the diameter). It has been found, that in order to avoid a macroscopic formation of steps in epitaxy processes following manufacture as described above, values of 6 or less, preferably 1,5 or less, more preferably 0,8 or less, are particularly suitable for this parameter. This parameter may also be referred to as "slip density" and is a dimensionless parameter.

A further embodiment not forming part of the invention as defined in the appended claimsrelates to a wafer, obtained from a AIII-BV-compound semiconductor single-crystal or particularly to a wafer obtained therefrom by separation, wherein the wafer has a distribution of a specific electrical resistance within a cross sectional area perpendicular to its central axis, and wherein a global standard deviation (*σ* global) of that distribution may amount to 16.0 % or less of a mean value of the specific electrical resistance within the cross sectional area of the wafer, wherein the global standard deviation is based on a characteristic length of 10 mm and an edge exclusion of 1 mm is considered.

According to specific embodiments also not forming part of the invention as defined in the appended claims, the AIII-BV-compound semiconductor is GaAs and the diameter of the wafer amounts to 150 mm, or 6 inches, or less, and the global standard deviation (*σ* global) of that distribution amounts to 4.0 % or less of a mean value of the specific electrical resistance within the cross sectional area of the wafer.

According to other specific embodiments not forming part of the invention as defined in the appended claims, the AIII-BV-compound semiconductor is GaAs and the diameter of the wafer amounts to 200 mm or 8 inches, more, and the global standard deviation (*σ* global) of that distribution amounts to 16.0 % or less of a mean value of the specific electrical resistance within the cross sectional area of the wafer.

According to still other specific embodiments not forming part of the invention as defined in the appended claims, the AIII-BV-compound semiconductor is InP and the diameter of the wafer preferably amounts to 100 mm, or 4 inches, and the global standard deviation (*σ* global) of that distribution amounts to 17.0 % or less of a mean value of the specific electrical resistance within the cross sectional area of the wafer.

Such parameters describing electrical properties of a single crystal and/or wafer include, in particular, the electrical resistance ρ. A well-known spatially resolved measurement of the electrical resistance ρ can be carried out with the so-called COREMA (COntactless RE-sistivity MApping) (Jantz, W. and Stibal, R. in: "Contactless resistivity mapping of semi-insulating substrates". III-Vs Review 6[4], 38-39. 1993; and Stibal, R., Wickert, M., Hiesinger, P., and Jantz, W. in "Contactless mapping of mesoscopic resistivity variations in semi-insulating substrates", Materials Science and Engineering B 66[1-3], 21-25, 1999). A typical spatial resolution of the method is in the range of 1 mm² and the mapping may be carried out over the entire surface as reflected by the term cross sectional area as used herein, except the edge exclusion.

The determination of a global, local and "total" standard deviation from corresponding measurement data is described in DE 10 2007 026 298 A1 and WO 2008/148542 A1 (or US 8,652,253 B1). The content of pages 20 to 23 of WO 2008/148542 A1 will also be summarized below:
Accordingly, the COREMA measurement data of the points are divided: for each point (x,y) in the cross-section or wafer plane perpendicular to the center axis, a regression plane is calculated from the measurement data of those neighboring points that lie inside a circumcircle with the radius ζ of it, i.e. the characteristic length described above: ${ρ}_{measured} = {ρ}_{regression plane} + {ρ}_{variation}$ (4)

The measured resistance ρ is expressed as the sum of two summands. Where ρ_{regression plane} is the value of the regression plane at the point (x,y) and ρᵥₐᵣᵢₐₜᵢₒₙ is the distance between the function value of the regression plane and the measured value.

A least-squares fit of a plane ρ (x,y) =a+bx+cy for N data points may be calculated uniquely by solving the linear equation system $\left(\begin{matrix}N & \sum {x}_{i} & \sum {y}_{i} \\ \sum {x}_{i} & \sum {x}_{i}^{2} & \sum {x}_{i} {y}_{i} \\ \sum {y}_{i} & \sum {x}_{i} {y}_{i} & \sum {y}_{i}^{2}\end{matrix}\right) \left(\begin{matrix}a \\ b \\ c\end{matrix}\right) = \left(\begin{matrix}\sum {ρ}_{i} \\ \sum {x}_{i} {ρ}_{i} \\ \sum {y}_{i} {ρ}_{i}\end{matrix}\right)$ (5)

The degree of homogeneity of the electrical resistance on different length scales across the wafer surface may now be expressed as follows:
1. the total standard deviation: ${σ}_{total} = \sqrt[2]{\frac{{\sum }_{i = 1}^{N} {\left({ρ}_{i}-\overline{ρ}\right)}^{2}}{N - 1}} mit \overline{ρ} = \frac{1}{N} {\sum }_{i = 1}^{N} {ρ}_{i}$ (6)
2. the local standard deviation: ${σ}_{lokal} = \sqrt[2]{\frac{{\sum }_{i = 1}^{N} {\left({ρ}_{i}-{ρ}_{{p}_{i}}\right)}^{2}}{N - 1}}$ (7) with *ρ_{pᵢ}* being a function value of the regression plane at point (xᵢ, yᵢ); and
3. the global standard deviation: ${σ}_{global} = \sqrt[2]{\frac{{\sum }_{i = 1}^{N} {\left({ρ}_{{p}_{i}}-{\overline{ρ}}_{p}\right)}^{2}}{N - 1}} , mit {\overline{ρ}}_{p} = \frac{1}{N} {\sum }_{i = 1}^{N} {ρ}_{{p}_{i}} .$ (8)

The measured variable (parameter) is examined on different length scales for a more precise analysis. A range in the order of a few dislocation cells or grains (the radius ζ amounts to 5 - 10 mm) is denoted as local. Fluctuations over the entire wafer with a minimum resolution of the radius ζ are referred to as being global. The fluctuations on different length scales can be due to physically different causes.

The measurement of mappings with high lateral resolution is required for the separate consideration of local and global fluctuations in the measured electrical resistivity. Measurement fields with a smaller distance to the wafer edge than the edge exclusion are not taken into account in the evaluation.

Accordingly, two variables can be defined: a boundary exclusion and a characteristic length ζ, after which the numerical calculation of the variables is unambiguously defined and can be reproduced by anyone.

In the COREMA mapping of the electrical resistance ρ, the global fluctuation is determined by a slow variation of a defect budget. The global fluctuations are greater than the local fluctuations, and the standard deviation across all measured values of the electrical resistance is therefore more a measure of the global variation.

Considering for example wafers having a diameter of 150 mm, all measurements may carried out with a scan width of 160 x 160 mm and 320 x 320 data points in the x and y directions, averaging over ζ = 10 mm and an edge exclusion of 1 mm in this case.

Against this background, a particular embodiment of a wafer according to this aspect, which does not form part of the invention as defined in the appended claims, provides that a corresponding value of the relative global standard deviation (*σ* global divided by the mean value over the entire wafer) of the electrical resistance - measured only in an edge area under consideration of an edge exclusion of 1 mm - amounts to 35,0 % or less, wherein a width of the edge area is defined by a distance of 3 mm or less measured from an outer edge of the wafer with an edge exclusion of 1 mm.

With such a value, acceptable conditions can already be created within an edge area with regard to electrical parameters in terms of their homogeneity, so that even this edge area, i.e., wafer surface sections below a distance of 3 mm from the wafer edge, may now also be considered for the subsequent manufacturing of devices.

A further embodiment of the wafer not forming part of the invention as defined in the appended claims provides that a mean value or a median value of a distribution of a residual strain content within an annular edge area of a cross sectional area of the single crystal or wafer, respectively, perpendicular to its central axis (M) may amount to 2.5×10⁻⁶ or less, preferably 1.6×10⁻⁶ or less, wherein the residual strain in the cross-sectional area within the edge area of the single crystal or the wafer is derived in a spatially resolved manner from measurements according to the SIRIS method, wherein the lateral resolution of the spatially resolved measurement is 100 µm, wherein the width of the edge area is defined by a distance of 3 mm or less measured from the outer edge of the single crystal or wafer with an edge exclusion of 1 mm.

This further embodiment provides for the simultaneous specification of electrical (homogeneity of the specific electrical resistance) and mechanical parameters (such as residual strain or residual stress) for the edge area. Mechanical parameters are closely related to structural perfection (e.g. represented by EPD). Structural perfection and electrical homogeneity can be contradictory properties with regard to their quality in a specific crystal: if one parameter has excellent values, the other can still leave a lot of potential open and vice versa. This may be due to the generally known interaction between extrinsic and intrinsic point defects, which are responsible for electrical material properties, and structural defects such as dislocations or grain boundaries. Microsegregation may be observed hereby. If structural defects are very dense, the concentration inhomogeneities are small, so that a satisfactory homogeneity of the electrical properties is obtained. In the opposite case, the mean distances between structural defects are large, so that relatively large differences in concentration may occur for point defects as a result of microsegregation.

Residual strain may be be calculated directly from the residual shear stress determined by measurement according to Kelly, PA. Mechanics Lecture Notes: An introduction to Solid Mechanics, available from http://homepages.engineering.auckland.ac.nz/ ~pkel015/SolidMechanicsBooks/index.html, http://homepages.engineering.auckland.ac.nz/~pkel015/SolidMechanicsBooks/Part_I I/04_ElasticityPolar/ElasticityPolars_Complete.pdf as follows: The relationship between two-dimensional stress and strain is $\begin{matrix}{ε}_{rr} = \frac{\partial {u}_{r}}{\partial r} \\ {ε}_{θθ} = \frac{1}{r} \frac{\partial {u}_{θ}}{\partial θ} + \frac{{u}_{r}}{r} \\ {ε}_{rθ} = \frac{1}{2} \left(\frac{1}{r}\frac{\partial {u}_{r}}{\partial θ}+\frac{\partial {u}_{θ}}{\partial r}-\frac{{u}_{θ}}{r}\right)\end{matrix} 2 - D Strain - Displacement Expressions$

The following applies to a plane stress and strain state, respectively: $\begin{matrix}{ε}_{rr} = \frac{1 + ν}{E} \left[\left(1-ν\right){σ}_{rr}-{νσ}_{θθ}\right] , {ε}_{θθ} = \frac{1 + ν}{E} \left[-{νσ}_{rr}+\left(1-ν\right){σ}_{θθ}\right] , {ε}_{rθ} = \frac{1 + ν}{E} {σ}_{rθ} \\ Hooke ′ s Law \left(Plane Strain\right)\end{matrix}$

Consequently, residual strain may be calculated from: $\left|St-Sl\right| = \left|{ε}_{θθ}-{ε}_{rr}\right| = \left|-\frac{ν + {ν}^{2}}{E}\left({σ}_{rr}-{σ}_{θθ}\right)+\frac{1 - {ν}^{2}}{E}\left({σ}_{θθ}-{σ}_{rr}\right)\right|$ $\left|St-Sl\right| = \frac{1 + ν}{E} \left|{σ}_{θθ}-{σ}_{rr}\right|$ $\left|St-Sl\right| = 2.23 ⋅ {10}^{- 11} \frac{1}{Pa} \left|{σ}_{θθ}-{σ}_{rr}\right| = 4.45 ⋅ {10}^{- 11} \frac{1}{Pa} \left|τ\right|$ with $τ = \frac{1}{2} \left({σ}_{1}-{σ}_{2}\right) .$

The material constants denoted as elasticity constant E and transverse contraction number v (or Poisson's ratio) are for GaAs E = 85.9 GPa, v = 0.31 and for InP E = 61.1 GPa, v = 0.36.

The lateral residual shear stress distribution may be measured by determining the photoelastic infrared depolarization using a dark-field polariscope in transmission (e.g: Vertical integrating photoelasticity measurement in transmission with lateral resolution, Scanning Infrared Stress Inspection System (SIRIS): s.a. Herms, M., Irmer, G., Kupka, G. et al: "Comparative Study of the Photoelastic Anisotropy of Si and GaAs". J. Electron. Mater. 49, 5205-5212 (2020), https://doi.org/10.1007/s11664-020-08141-7, see also: Geiler, Hans D. et al.: "Photoelastic characterization of residual stress in GaAs-wafers." Materials Science in Semiconductor Processing 9 (2006): 345-350). Using multi-polarization analysis with multiple measurements of a wafer with a different axis of rotation, the residual stress can be determined quantitatively for the entire wafer surface without the dependence on the crystallographic direction, as was the case with the SIRD method. However, the values given here can also apply objectively and independently of the measurement method. Further information on the method and evaluation can be found in the publications: Higginbotham, C.W., Cardona, M. and Pollak, F.H., "Intrinsic Piezobirefringence of Ge, Si and GaAs", Phys. Rev. 184, 821 (1969); Timoshenko, S. and Goodier, J. N., Theory of Elasticity, McGraw-Hill Book Company, Inc. 1951; Suzuki, T., Yasutomi, T., Tokuoka, T., Yonenaga, I., "Plastic deformation of GaAs at low temperatures", Phil. Mag. A, 1999, Vol. 79, No. 11, 2637-2654; Herms, M., Wagner, M., Kayser, S., Kiessling, F. M., Poklad, A., Zhao, M., Kretzer, U., "Defect-induced Stress Imaging in Single and Multi-crystalline Semiconductor Materials", Materials Today: Proceedings, Volume 5, Issue 6, Part 3, 2018, Pages 14748-14756.

The measured quantity in each case is a phase shift between different polarization directions of a light beam, which is dependent on voltage-induced birefringence (photoelastic effect). The phase shift Δ is correlated by Wertheim's law from stress optics with the difference of the principal stress values Δσ and thus the maximum shear stresses via a stress-optical material constant. The stress-induced change in the inverse dielectric tensor ΔB is linearly related to the stress or strain for small changes. In particular, there is a high degree of linearity in the range of stresses of up to 1 MPa considered here, especially because these stresses are orders of magnitude lower than the critical shear stresses at room temperature (which are 600 MPa or more). The minimum resolvable shear stress with the SIRIS method is approx. 0.1 kPa, this value represents a lower limit of the specified residual stresses.

Consequently, according to the present embodiment, which - as mentioned above-does not form part of the invention as defined in the appended claims - wafers are provided with edge areas in such a way that the latter are now also at least partially available (i.e., still without edge exclusion) for subsequent device production.

An embodiment of the wafer according to this aspect not forming part of the invention as defined in the appended claims provides that a mean value or a median value of a distribution of the residual stress content within the edge area amounts to 1.1×10⁻⁶ or less.

A further aspect not forming part of the invention as defined in the appended claims relates to a wafer produced by separation from an AIII-BV compound semiconductor single crystal, wherein an average value of a distribution of a residual stress content within an annular edge area of the cross-sectional area of the wafer perpendicular to the center axis (M) thereof amounts to 60 kPa or less, wherein the residual stress in the cross-sectional area in the edge area of the single crystal or the wafer is measured spatially resolved according to the SIRIS method, wherein the lateral resolution of the spatially resolved measurement amounts 100 µm, wherein a width of the edge area is defined by a distance of 3 mm measured from an outer edge of the single crystal or wafer with an edge exclusion of 1 mm.

According to this aspect as well, wafers are provided, such that their edge areas are at least partially (i.e., except edge exclusion) available for a subsequent manufacture of devices.

An embodiment of the wafer according to this aspect not forming part of the invention as defined in the appended claims provides that a mean value of the distribution of the residual stress content in the edge area amounts to 30 kPa or less, preferably 25 kPa or less.

According to a specific embodiment not forming part of the invention as defined in the appended claims, the mean value of a distribution of the residual stress content within an annular edge area of a cross sectional area of the single crystal or wafer perpendicular to its central axis (M) amounts to 60 kPa or less wherein the AIII-BV-compound semiconductor is GaAs and a diameter of the wafer amounts to 200 mm, or 8 inches, or more, respectively.

According to another specific embodiment not forming part of the invention as defined in the appended claims, the mean value of a distribution of the residual stress content within an annular edge area of a cross sectional area of the single crystal or wafer perpendicular to its central axis (M) amounts to 30 kPa or less wherein the AIII-BV-compound semiconductor is GaAs and a diameter of the wafer amounts to 150 mm, or 6 inches respectively.

According to other embodiments also not forming part of the invention as defined in the appended claims, the AIII-BV-compound semiconductor is InP and a diameter of the wafer amounts to 100 mm, or 4 inches, respectively, or more, and the mean value of a distribution of the residual stress content within an annular edge area of a cross sectional area of the single crystal or wafer perpendicular to its central axis (M) amounts to 60 Kpa or, preferably 30 kPa or less.

It should be noted that further embodiments not forming part of the invention as defined in the appended claims also provide for single crystals or wafers which in a combined manner provide properties according to the above-mentioned independent aspects, e.g. a wafer which has the parameter values specified in relation to the slip lines emanating from the edge region (fraction of dislocation etch pits to be assigned to slip lines, total length of the slip lines in relation to the wafer diameter, number/frequency of slip lines in relation to the wafer circumference), which complies with the value ranges for electrical resistance in the edge area as stated above, e.g. determined in COREMA measurements, and which has a residual mechanical shear stress and/or strain in the edge area.

These and all the wafers or single crystals listed separately above may have a diameter perpendicular to the central axis of between 100 mm and 220 mm, including the boundary values of the specified interval. In particular, a nominal diameter may be 100 mm (corresponding to 4"), 150 mm (corresponding to 6") or 200 mm (corresponding to 8").

Furthermore, the AIII-BV compound semiconductor single crystals described above or wafers produced therefrom by separation may in particular comprise gallium arsenide (GaAs) or indium phosphide (InP).

It should be noted that the arrangement proposed herein is set up, among others, to carry out crystallization according to the VGF process or alternatively also according to the VB process or alternatively to carry out a combination of the VGF and VB processes, i.e. a change in the temperature field and movement of the crucible relative to the heater or the heating elements.

Further advantageous embodiments of the invention may be found in the dependent claims.

### Brief Description of Drawings:

The invention will now be explained in more detail with the reference to the drawings. Therein
- Fig. 1:: shows a schematic cross-section of device for manufacturing an AIII-BV compound semiconductor single crystal from the melt of a raw material according to an embodiment;
- Fig. 2:: shows an enlarged view of the formation of a phase boundary between the raw melt and the growing single crystal in the area of the crucible wall when using the device from Fig. 1 compared to the conventional case;
- Fig. 3:: shows in a purely schematical manner those edge areas at an edge of a wafer that are only reasonably accessible for measuring the various parameters such as etch pit density (EPD), specific electrical resistance, residual mechanical shear stress or strain;
- Fig. 4:: shows a section of a wafer surface with dislocation etch pits formed therein to capture a slip line;
- Fig. 5:: shows a section of a wafer surface with dislocation etch pits formed therein to detect a slip line;
- Fig. 6:: as Fig. 6, but the corresponding top view of the flat wafer surface;
- Fig. 7:: shows for an 8" GaAs wafer (diameter: 200 mm) according to an embodiment, a distribution of etch pits across the surface of the wafer;
- Fig. 8:: shows a determined distribution of those dislocation etch pits from Fig. 7 that can be assigned to slip lines that originate in a defined edge area at a distance of 2 to 5 mm from the outer wafer edge (or touch this edge area with dislocation etch pits);
- Fig. 9:: shows a distribution of a residual stress measured with SIRIS on six 6" GaAs wafers made of two different single crystals at a distance of ≤ 3 mm from the wafer edge (edge exclusion 1 mm);
- Fig. 10:: shows a distribution of the residual strain calculated from the residual stress measured with SIRIS on six 6" wafers made of two single crystals in accordance with Fig. 9 at a distance of ≤ 3 mm from the wafer edge, whereby the plane stress state was converted into a plane strain state with the material constants E = 85.9 GPa, v = 0.31 (for GaAs);
- Fig. 11:: shows, according to an embodiment, a profile of values determined in COREMA measurements for the specific electrical resistance across the surface of the wafer, whereby wafers with 1 mm oversize with missing edge rounding (solid line) and those with edge rounding and without oversize are measured for comparison (dashed line);
- Fig. 12:: shows for a 4" InP wafer (diameter: 100 mm) a distribution of etching pits across the surface of the wafer (cross sectional area);
- Fig. 13:: shows for a further 4" InP wafer (diameter: 100 mm) a distribution of etching pits across the surface of the wafer (cross sectional area);
- Fig. 14:: shows for a 6" GaAs wafer (diameter: 150 mm) a distribution of etching pits across the surface of the wafer (cross sectional area);
- Fig. 15:: shows for a further 6" GaAs wafer (diameter: 150 mm) a distribution of etching pits across the surface of the wafer (cross sectional area);
- Fig. 16:: shows for a 4"InP wafer (diameter: 100 mm) a distribution of the specific electrical resistance across the surface of the wafer (cross sectional area);
- Fig. 17: shows for a further 4"InP wafer (diameter: 100 mm) a distribution of the specific electrical resistance across the surface of the wafer (cross sectional area);
- Fig. 18: shows for an 8" GaAs wafer (diameter: 200 mm) a distribution of the resistivity across the surface of the wafer (cross sectional area);
- Fig. 19:: shows for a further 8" GaAs wafer (diameter: 200 mm) a distribution of the resistivity across the surface of the wafer (cross sectional area);
- Fig. 20:: shows for still a further 8" GaAs wafer (diameter: 200 mm) a distribution of the resistivity across the surface of the wafer (cross sectional area);
- Fig. 21:: shows for even a further 8" GaAs wafer (diameter: 200 mm) a distribution of the resistivity across the surface of the wafer (cross sectional area).

### Detailed Description of Preferred Embodiments:

In the following description of preferred embodiments, it should be taken into account that the present disclosure of the various aspects is not limited to the details of the structure and arrangement of the components as shown in the following description and in the figures. The embodiments can be put into practice or implemented in various ways. It should also be noted that the expressions and terminology used herein are used for the purpose of specific description only and should not be construed by the skilled person as such in a limiting manneWhor. Furthermore, in the following description, identical reference signs in the various embodiments or figures denote identical or similar features or objects, so that in some cases a repeated detailed description of the same is dispensed with in order to preserve the compactness and clarity of the description.

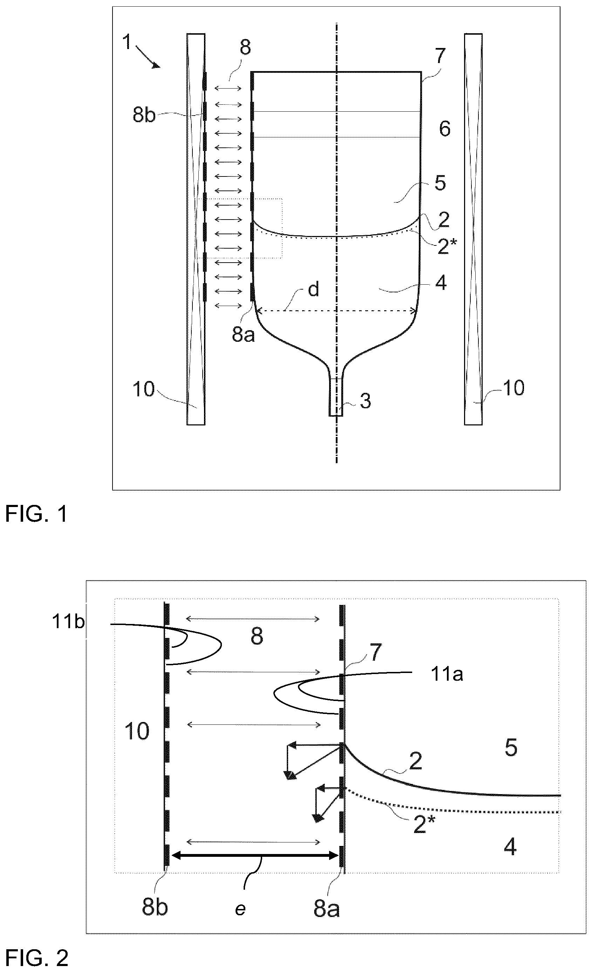

Fig. 1 shows a schematic cross-section of a device 1 for manufacturing an AIII-BV compound semiconductor single crystal from the melt of a raw material according to an embodiment. The device 1 comprises a crucible 6 for holding the raw melt, or before melting: for holding the raw material, and a component 10 surrounding the crucible 6. The device also includes a heater including one or more heating elements and a controller that controls the heater to melt the raw material and create and maintain a directed temperature field during controlled cooling. In Fig. 1, the heater is not shown separately from the surrounding component 10, but is nevertheless present. The crucible has a central axis M and the heater is located behind / beyond the component 10 surrounding the crucible when viewed from the central axis M of the crucible 6.

The crucible 6 has a seed channel 3 in which a seed crystal is inserted. Starting from the seed channel 3 having a diameter of, e.g., 5 - 100 mm, a tapered (conical) crucible section extends with an increasing diameter and from this a cylindrical crucible section extends with a diameter d of, e.g., 100 to 120 mm, 150 - 170 mm or 200 to 220 mm. The specified intervals for the diameter correspond to a nominal diameter of the wafers to be obtained from the single crystal by separation (cutting) plus an oversize of, e.g., 0 - 20 mm, which takes into account the removal of uneven or uneven surface material from its lateral surface. The AIII-BV compound semiconductor single crystal can be made of GaAs or InP. Without limiting the generality, the nominal diameter of an InP single crystal may be 100 mm (4") or 150 mm (6"), and the nominal diameter of a GaAs single crystal may be 150 mm (6") or 200 mm (8"). Other diameters (e.g. 200 mm or 8" for InP or 12" or 300 mm for GaAs) and materials (e.g. GaP) are also possible in principle.

In a lower section of the crucible 6 shown in Fig. 1, a single crystal 4 is shown growing upwards from the seed crystal. A crystal growth or phase boundary 2, 2* represents a transition to the raw melt 5 located above. The raw melt 5 is covered by a protective layer of boron oxide (B₂O₃) (not shown), which may also extend between the melt or the single crystal and the crucible wall 7. The heater, which is not shown in Fig. 1, generates a temperature field in the crucible 6 that is essentially parallel to the central axis M. The gradient points downwards in a vertical direction. As can be seen in Fig. 1, but especially in the enlarged view of Fig. 2, the phase boundary 2 or 2* does not form a linear flat surface, but is curved towards the edge of the crucible 6, i.e., towards an outer crucible wall 7, in a direction parallel to the central axis M. As described above, this is because, on the one hand, heat can be transported along the outer crucible wall 7, which is more efficient than the heat transport through the melt and/or the crystal material itself, and on the other hand, heat losses due to thermal radiation are definitely relevant here. As a result, edge areas of the single crystal and the overlying melt are subject to a thermal gradient component, which in this case is also radial, so that thermal stress may occur in the edge area of the single crystal during cooling immediately after crystallization, leading to increased formation of dislocations as compared to the interior of the crystal (closer to the central axis M).

However, Fig. 1 also depicts measures according to the invention that are intended to counteract this deviation from a linear phase boundary. In particular, in the embodiment, the crucible outer wall 7, which is itself formed from pyrolytic boron nitride (pBN), has an outer face 11a, which is formed by a shiny metallic coating 8a made of platinum. Platinum has a melting point of 2041.4 K, which is significantly higher than that of GaAs (1511 K), InP (1343 K) or GaP (1621 K), and may technically be deposited without further ado in a suitable manner at the crucible formed from pBN (melting point BN: 3240 K). Without limiting the generality, sputtering, for example, may be considered (including bombarding platinum with an electron beam to vaporize the platinum and deposit it on or against the crucible wall). Platinum layer thicknesses between 1 µm and 10 µm may be sufficient, but smaller or greater thicknesses are also possible. In the embodiment example, the outer face 11a of the crucible wall is essentially formed over its entire surface - at least in the region of the cylindrical crucible section - by the coating 8a.

Furthermore, the component 10 surrounding the crucible, which component may be a hard graphite shell or a graphite-coated quartz tube (so-called liner), for example, has an inner surface 11b, which is arranged opposite to the outer face 11a of the crucible wall 7 formed by the coating 8a of platinum via (sandwiching) an intermediate space 8, and being separated from the outer face 11a by a distance e. Hereby, the inner face 11b is also formed by a shiny metallic (or optionally also metallic rough) coating 8b, which is herein formed from a metal. The intermediate space 8 is limited by the inner face 11b of the component 10 surrounding the crucible and the outer face 11a of the crucible wall 6 (but may be open at the front or top as shown in Fig. 1). The distance e may, for example, amount to between 1 mm and 15 mm (including boundary values of the interval), preferably 1 to 3 mm.

Across the intermediate space 8 an exchange of thermal radiation occurs between the crucible 6 and the surroundings (for example component 10). Due to the shiny metallic coating 8a formed from platinum, an emissivity ε₁ of the oute face of the crucible wall 7 amounts in the specific embodiment to a value of 0.01, wherein the emissivity indicates How much radiation the crucible wall emits in comparison to an ideal radiant heater. Furthermore, the shiny metallic coating 8b of the inner face of the component surrounding the crucible has an emissivity ε₂ which amounts to for example 0.01. With equation (3), the degree of radiation exchange E in this design example is thus a value of around 0,005. The exchange of thermal radiation is thus significantly reduced.

In Fig. 1 the coatings 8a and 8b are indicated only on the left side for the purpose of simple illustration and comparison with prior art. Nevertheless, in the present embodiment, the actual coatings 8a and 8b extend around the circumference of the inner and outer faces 11a, 11b, respectively. The corresponding phase boundary is shown as a dotted line and marked with the reference symbol 2*. On the right-hand side of Fig. 1, the coating is omitted for comparison, which corresponds to the conventional structure. The emissivity ε₁ on the side of the outer face of the crucible wall 6 and the emissivity ε₂ on the side of the inner face of the component 10 herein (conventional example) amount for example to 0.5 and 0.8, respectively, such that the radiation exchange degree E has a value of 0.44. The corresponding phase boundary is provided in Fig. 1 with a reference numeral 2 and has - in comparison with phase boundary 2* - a considerably larger phase boundary deflection, as can particularly be seen in Fig. 2.

For both phase boundaries 2, 2*, the angle of inclination of the phase boundary at the crucible wall 7 is also indicated by arrows in Fig. 2. As described above, the shape of the phase boundary is unfortunately beyond direct observation - however, thermal modeling (latent heat, heat conduction, thermal radiation and laminar convection) using the CGSIM software package (https://www.str-soft.com/) has been able to confirm the effect of lower phase boundary deflection due to the measures taken at the crucible edge for lower degrees of radiation exchange (values calculated for growing 6" GaAs single crystal, growth rate 2 mm/h):

**Table 1:**

| *ε*₁ | *ε*₂ | phase boundary deflection, absolute [mm] | phase boundary deflection, relative to conventional case | Inclination angle (w.r.t. horizontal direction - ideal: 0°) |
|---|---|---|---|---|
| 0,5 | 0,8 | 14,2 | 100% | 42° |
| 0,1 | 0,1 | 8,7 | 61% | 37° |
| 0,01 | 0,01 | 5,2 | 37% | 32° |

In Table 1 thereis is provided the inclination angle between the phase boundary and a horizontal direction at or close to the crucible wall 7, unlike Fig. 2 where a crucible contact angle is shown. The inclination angle is calculated as 90° minus the crucible contact angle. An inclination angle of 0° corresponds to a phase boundary that is plane at the crucible wall 7.

For a growth rate of 0.4 mm/h at emissivities of 0.5 and 0.8, a phase boundary deflection of 11.0 mm with a crucible contact angle of 38° is obtained.

Table 2 lists the values obtained from corresponding thermal modeling for indium phosphide (6" InP single crystal). The growth rate used here also amounts to 2 mm/h.

**Table 2:**

| *ε*₁ | *ε*₂ | phase boundary deflection, absolute [mm] | phase boundary deflection, relative to conventional case | Inclination angle (w.r.t. horizontal direction - ideal: 0°) |
|---|---|---|---|---|
| 0,5 | 0,8 | 12,0 | 100% | 40° |
| 0,1 | 0,1 | 6,4 | 53% | 34° |
| 0,01 | 0,01 | 4,4 | 37% | 31° |

Furthermore, the influence of the growth rate on the deflection of the phase boundary was also investigated in the thermal modeling. The results are summarized in Table 3, here using the example of 6" GaAs single crystals:

**Table 3:**

| *ε*₁ | *ε*₂ | growth rate [mm/h] | phase boundary deflection, absolute [mm] | phase boundary deflection, relative to conventional case | Inclination angle (w.r.t. horizontal direction - ideal: 0°) |
|---|---|---|---|---|---|
| 0,5 | 0,8 | 0,4 | 10,4 | 72% | 33° |
| 0,5 | 0,8 | 2 | 14,5 | 100% | 42° |
| 0,5 | 0,8 | 5 | 22,7 | 156% | 51° |

Table 4 shows the corresponding results from thermal modeling for 6" InP single crystals:

**Table 4:**

| *ε*₁ | *ε*₂ | growth rate [mm/h] | phase boundary deflection, absolute [mm] | phase boundary deflection, relative to conventional case | Inclination angle (w.r.t. horizontal direction - ideal: 0°) |
|---|---|---|---|---|---|
| 0,5 | 0,8 | 0,4 | 11,0 | 92% | 38° |
| 0,5 | 0,8 | 2 | 12,0 | 100% | 40° |
| 0,5 | 0,8 | 5 | 14,7 | 123% | 45° |

For the different emissivities, the influence of the thermal conductivity of the crucible wall material (or its composition) on the resulting phase boundary deflection can also be determined from the thermal modeling. The result for 6" GaAs single crystals is shown in Table 5:

**Table 5:**

| *ε*₁ | *ε*₂ | Thermal conductivity of the crucible: perpendicular / parallel to the crucible surface [W/(m*K)] | phase boundary deflection, absolute [mm] | phase boundary deflection, relative to conventional case | Inclination angle (w.r.t. horizontal direction - ideal: 0°) |
|---|---|---|---|---|---|
| 0,5 | 0,8 | 3 / 3 (e.g.. glassy-carbon) | 10,9 | 75% | 23° |
| 0,5 | 0,8 | 3 / 60 (pBN standard) | 14,5 | 100% | 42° |
| 0,5 | 0,8 | 3 / 120 (pBN modified) | 16,1 | 111% | 46° |

Table 6 shows the corresponding results from thermal modeling for 6" InP single crystals:

**Table 6:**

| *ε*₁ | *ε*₂ | Thermal conductivity of the crucible: perpendicular / parallel to the crucible surface [W/(m*K)] | phase boundary deflection, absolute [mm] | phase boundary deflection, relative to conventional case | Inclination angle (w.r.t. horizontal direction - ideal: 0°) |
|---|---|---|---|---|---|
| 0,5 | 0,8 | 3 / 3 (e.g.,. glassy-carbon) | 8,6 | 72% | 18° |
| 0,5 | 0,8 | 3 / 60 (pBN standard) | 12,0 | 100% | 40° |
| 0,5 | 0,8 | 3 / 120 (pBN modified) | 14,1 | 118% | 46° |

In order to realize the desired emissivities for a given device, the values listed in the following Table 7 may be considered:

**Table 7:**

| material of component 10 surrounding the crucible, optionally with coating 8b: | *ε*₁ | material of crucible wall, optionally with crucible coating 8a: | *ε*₂ |
|---|---|---|---|
| Hard graphite | 0,8 | | |
| Hard graphite with pBN-layer | 0,5 | | |
| | | pBN-crucible | 0,5 |
| | | pBN- crucible with Pt- coating rough | 0,1 |
| | | pBN- crucible with Pt- coating shiny metallic | 0,01 |
| Hard graphite with rough metallic layer | 0,1 | | |
| Hard graphite mit shiny metallic layer | 0,01 | | |

In order to obtain a radiation exchange degree of 0,1 or less, it is sufficient according to the invention in view of equation (3) that just one side implements an emissivity of 0,1 while realising any kind of surface on the opposing side, using, e.g., data from Table 2. A suitability of materials for implementing emissivities dependent from temperature is known for example from: https://www.sciencedirect.com/science/article/abs/pii/S0017931019321623.

Furthermore, it was found in the simulations that the implementation of the measures according to the invention (coating to reduce the emissivity(ies)) may correspond to a reduced growth rate, which, however, may no longer be economical in production due to the increasing production costs. For example, the crystal growth rate can be reduced from 2.0 mm/h to 0.4 mm/h (five times the cooling time) by controlling the heater or the heating elements accordingly in a conventional setup in order to obtain a similar phase boundary deflection and a similar angle of inclination near the crucible edge as shown in Table 1 for device 1 according to the invention for the case ε₁ = 0.01 and ε₂ = 0.01. Unfortunately, values for the emissivity below 0.04 or even less are currently almost impossible to achieve technically - at least from an economic point of view.

Embodiments of the method according to the invention also provide for a provision of the device 1 as shown in Figs. 1 and 2, wherein the steps of inserting the seed crystal into the seed channel, filling the raw material (containing Ga and As; or In and P; etc.) into the crucible interior, melting the raw material to obtain the raw melt, up to slight melting of the seed crystal, implementing the directional temperature field, lowering the temperature level of the temperature field for long-term crystal growth in the vertical direction, and controlled cooling of the grown single crystal are performed. The reduced phase boundary deflection may thereby be improved by further slowing down the growth rate, for example to 1 mm/h or less, 0.5 mm/h or less or even 0.4 mm/h or less. Here, an economic trade-off can be made between the resulting higher yield (larger proportion of usable area at the respective wafer edge) and extended production time.

The device and the process enable the production of AIII-BV compound semiconductor single crystals and wafers obtained therefrom by separation, which have particularly excellent properties with regard to the wafer edge. Wafers with corresponding properties, which will be described below, could be produced by the device or by the aforementioned equivalent of reduced growth speed:

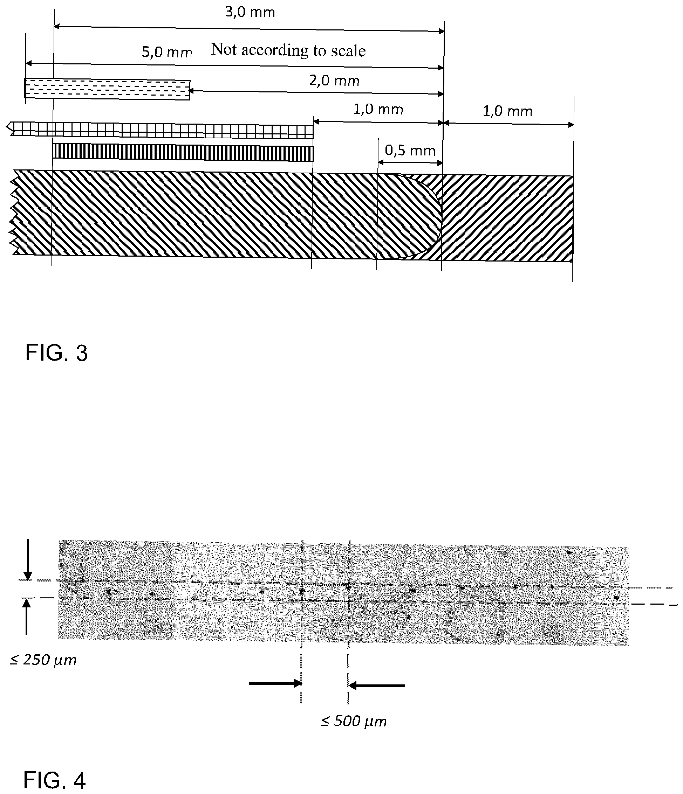

Fig. 3 firstly shows a purely schematic representation of edge areas at the wafer edge that are only reasonably accessible for measuring the various parameters such as etch pit density (EPD). For example, an edge exclusion (measured from the wafer edge) of 2 mm is required for the etch pit density to record the slip lines (slip dislocation lines) in accordance with the definition given above. The width is 3 mm, so that the edge area lies in an interval of 2 mm to 5 mm from the wafer edge.

In the measurements to determine the specific electrical resistance according to the COREMA method, the edge exclusion is 1 mm and the width of the edge area is 2 mm (interval: 1 mm to 3 mm from the wafer edge). However, this measurement takes place before the usual edge rounding (KV) of the wafer and with an oversize (over the nominal diameter) of a further 1 mm (by radius, the diameter is then 2 mm), because the measurements are otherwise too error-prone. The oversize is later removed from the non-edge-rounded wafer.

Fig. 4 shows an example of a section of a wafer surface with dislocation etch pits formed therein. The slight adaptation of the definition of slip lines required compared to the SEMI M10 standard is immediately apparent from this figure: the mutual distances between the etch pits are so large at low EPD that the existing definition would fail here. Furthermore, slight lateral deviations of the etch pits involved can be recognized for the slip line, which may result from interactions with other dislocations. Therefore, the definition given above, which is logically derived from SEMI M10, was used for the determination of slip lines (and also denoted as slip dislocation lines herein).

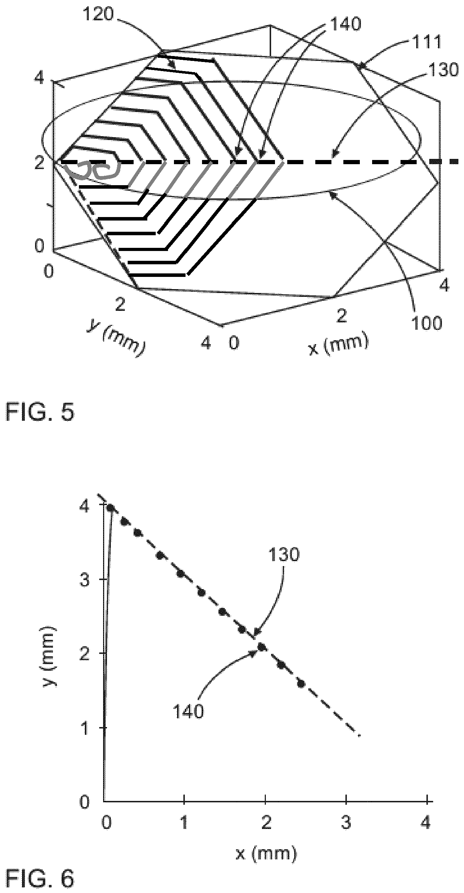

Fig. 5 shows a schematic illustration of the formation of slip lines. A slip plane 111 refers to a densely packed plane in the lattice with a comparatively large lattice spacing to the next plane. It is oriented at an angle to the wafer surface 100 or cross-sectional area of the single crystal before separation. In the slip plane, dislocation loops 120 are emitted starting from a Frank-Read source (visible on the left). These line up as dislocation etch pits 140 (if the surface is treated with a KOH solution) in a slip line 130 in the wafer surface 100. Fig. 6 shows the corresponding top view of the wafer surface 100.

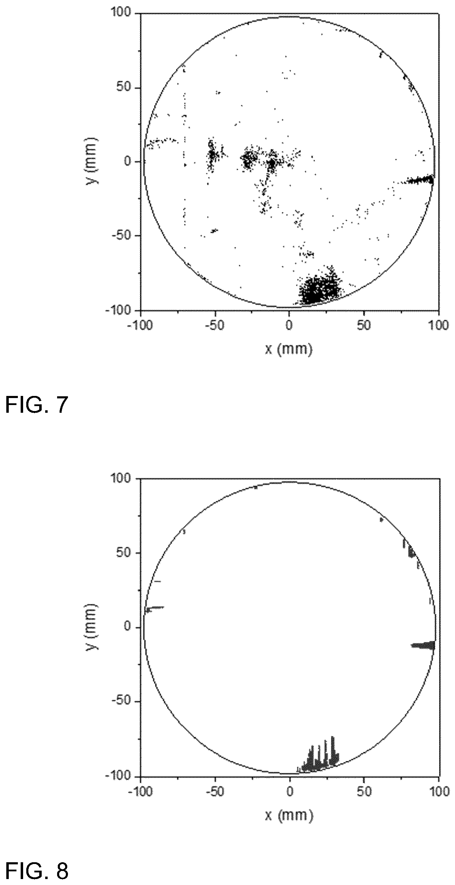

Fig. 7 shows a distribution of etch pits across the surface for an 8" GaAs wafer (diameter: 200 mm) similarly produced according to an embodiment of the invention as described above. Fig. 8 shows the distribution of the dislocation etch pits determined from the 8" GaAs wafer, which may be associated with slip lines, which originate and extend from the edge area as defined above. The measurements to determine the slip lines were carried out on semiconducting silicon-doped material (whereby the corresponding specific electrical resistance is in the range of 0.05 to 10 · 10¹⁸ cm⁻³, in particular 0.3 to 3 · 10¹⁸ cm⁻³). The average density of etch pits on the entire wafer surface (i.e., cross sectional surface, but without edge exclusion area: 2 mm) amounts to 112 cm⁻². The relative frequency of slip lines, which extend from the edge area of the single crystal or wafer within the planar wafer surface or cross sectional area, respectively, in relation to the length of circumference of the cross sectional area of the wafer or single cyrstal amounts to 0.27 cm⁻¹ in the embodiment shown in Figs. 7 and 8.

In the following Table 8, values measured or determined from measurement are shown for three 8" GaAs wafers (diameter: 200 mm), which were produced by separation from single crystals are provided:
- for the etch pit density ((a) averaged; (b) fraction of measurement fields with EPD = 0 cm⁻², (c) ... with EPD < 500 cm⁻², (d) ... with EPD < 1000 cm⁻²),
- for the fraction of dislocation etch pits, which may be associated with slip lines, which extend from the edge area of the wafer (simply represented as parameter *"slip degree*")*,*
- for total length of these slip lines related to (divided by) the wafer diameter (simply represented as parameter *"slip density*")*,* and
- for the frequency (number) of such slip lines related (divided by the wafer circumference (simply represented as parameter "*slip dislocation line density*").

**Table 8A:**

| Samples: | Wafer - Sample # 1 | Wafer - Sample # 2 | Wafer - Sample # 3 | Wafer - Sample # 4 [Figs. 7,8] |
|---|---|---|---|---|
| Epd avg. | 16 cm⁻² | 46 cm⁻² | 99 cm⁻² | 112 cm⁻² |
| A(EPD=0) | 98% | 96% | 88% | 89% |
| A(EPD<500) | 99% | 98% | 97% | 95% |
| A(EPD<1000) | 100% | 99% | 99% | 97% |
| *Slip degree* | 5% | 23% | 4% | 16% |
| *Slip density* | 0,68 | 5,8 | 1,42 | 8,04 |
| *Slip dislocation line density* | 0,05 cm⁻¹ | 0,18 cm⁻¹ | 0,10 cm⁻¹ | 0,25 cm⁻¹ |

The wafers with these low values for the *slip degree, slip density* and *slip disclocation line density* as defined above are particularly suitable for a subsequent use of the previously unused edge area at the wafer edge in an epitaxy step for the production of an electronic or optical component, without an intolerable morphologically macroscopic step formation on the surface, which exceeds the specified tolerance values with regard to the number and/or length of steps.

Studies have also been extended to GaAs wafers having a reduced diameter (6", or 150 mm), and to InP wafers.

Results of corresponding measurements with regard to three 6"-GaAs-Wafers (diameter: 150 mm), are depicted in Table 8B below:

**Tabelle 8B:**

| Samples: | Wafer - Sample # 8 | Wafer - Sample # 9 (Fig. 14) | Wafer - Sample # 10 (Fig. 15) |
|---|---|---|---|
| Epd avg. | 22 cm⁻² | 49 cm⁻² | 98 cm⁻² |
| A(EPD=0) | 97% | 94% | 91% |
| A(EPD<500) | 99% | 97% | 96% |
| A(EPD<1000) | 99% | 99% | 97% |
| *Slip degree* | 2% | < 0,5% | 14% |
| *Slip density* | 0,04 | 0,01 | 2,26 |
| *Slip dislocation line density* | 0,01 cm⁻¹ | < 0,005 cm⁻¹ | 0,21 cm⁻¹ |

Results of corresponding measurements with regard to three 4"-InP-Wafers (diameter: 100 mm), are depicted in Table 8C below:

**Tabelle 8C:**

| Samples: | Wafer - Sample # 5 | Wafer - Sample # 6 (Fig. 12) | Wafer - Sample # 7 (Fig. 13) |
|---|---|---|---|
| Epd avg. | 104 cm⁻² | 137 cm⁻² | 160 cm⁻² |
| A(EPD=0) | 90% | 77% | 77% |
| A(EPD<500) | 95% | 92% | 90% |
| A(EPD<1000) | 97% | 98% | 96% |
| *Slip degree* | 20% | < 0,5% | < 0,5% |
| *Slip density* | 2,39 | < 0,005 | 0,1 |
| *Slip dislocation line density* | 0,23 cm⁻¹ | < 0,005 cm⁻¹ | 0,01 cm⁻¹ |

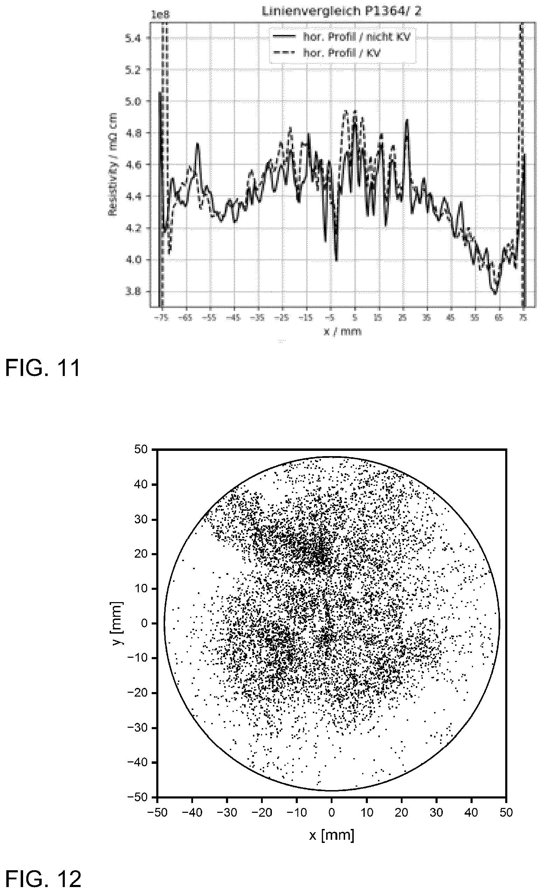

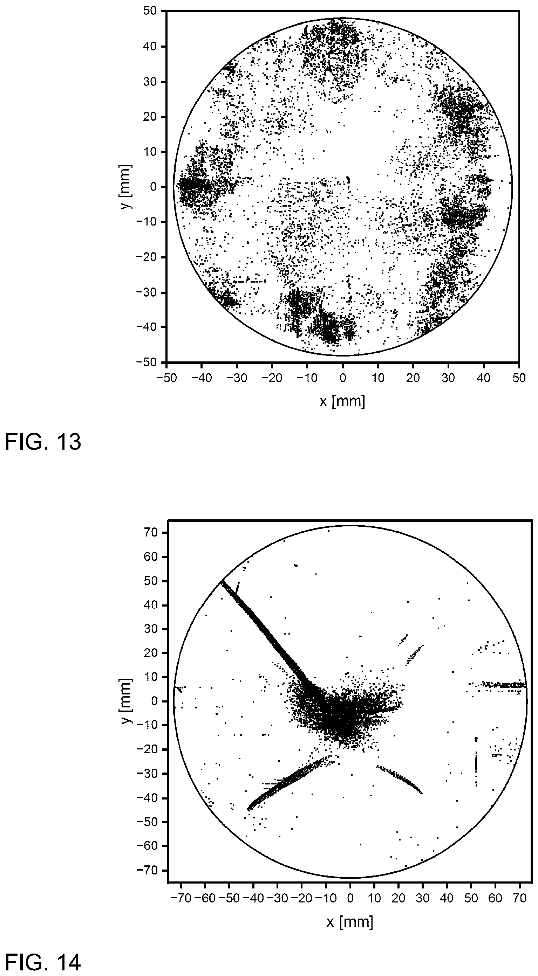

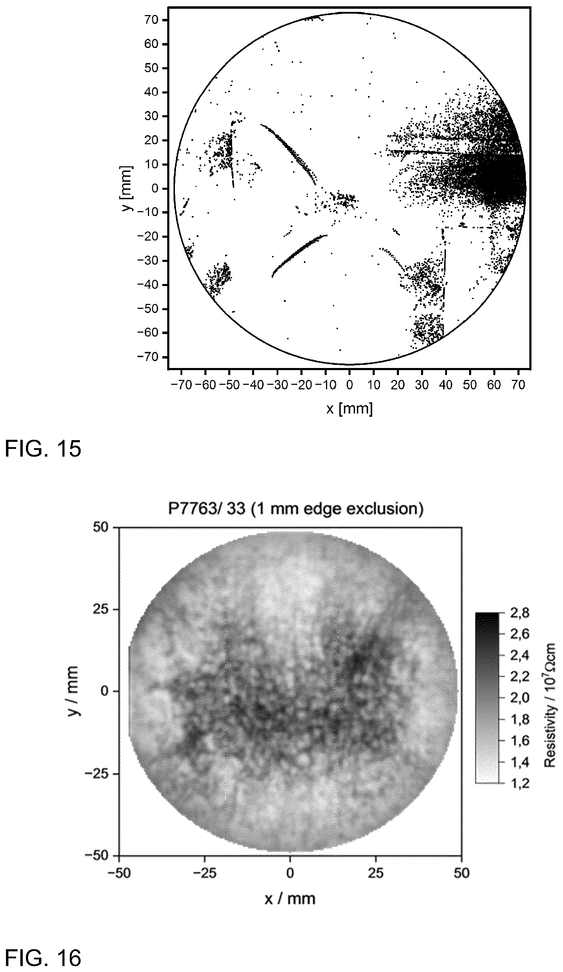

The same conclusions as with regard to 8" GaAs wafers manufactured according to embodiment of the invention may be drawn with respect to 6" GaAs wafers and 4" InP wafers. Figs. 12 -15 depict a distribution of etch pits across the surface for 6" GaAs wafers (wafer samples #9 and #10 in Figs. 14 and 15) and 4" InP wafers (wafer samples #7 and #7 in Figs. 12 and 13) in the same manner as in Fig. 7 for wafer sample #4 of an 8" GaAs wafer.

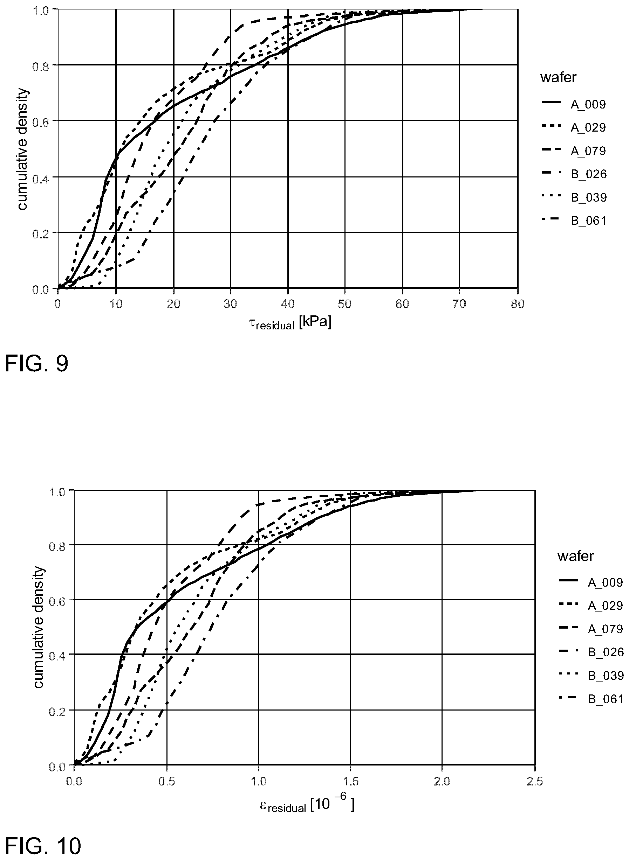

Figs. 9 and 10 reveal cumulative distributions of residual mechanical shear stress or residual strain measured using the SIRIS method (as described above) within the edge area defined by a distance of 1-3 mm from the wafer edge for six 6" GaAs wafers (diameter: 150 mm) according to embodiments of the invention.

Here, too, particularly low values were found, for example for the median value: 100% of all measured values (for each edge area of a respective wafer) for the residual stress were below 80 kPa, 80% of all measured values (for each edge area of a respective wafer) for the residual stress were below 50 kPa, and 50% of all measured values (for each edge area of a respective wafer) for the residual stress were significantly below 30 kPa, or more precisely below 25 kPa. In three of the six samples, the median value (50% of the measurement fields) was even less than 15 kPa.

The same applies to the residual strain calculated directly from the residual shear stresses determined for the material: 100% of all measured values (for each edge area of a respective wafer) for residual strain were below 2.50 × 10⁻⁶, 80% of all measured values (for each edge area of a respective wafer) for residual strain were below 1.53 × 10⁻⁶, and 50% (median value) of all measured values (for each edge area of a respective wafer) for residual strain were below 0.92 × 10⁻⁶, or more precisely below 0.75 × 10⁻⁶.

Table 9A below shows the mean (or average) values for the mechanical parameters of residual stress and residual strain determined with regard to the samples according to the embodiments:

**Table 9A:**

| Samples: Single Crystal (6" GaAS) | Samples: Wafer # | Residual Stress Average or mean value [kPa] | Residual Strain Average or mean value [10⁻⁶] |
|---|---|---|---|
| L0958 | 9 | 16,7 | 0,51 |
| L0958 | 29 | 15,5 | 0,47 |
| L0958 | 79 | 21,1 | 0,64 |
| L9852 | 26 | 14,4 | 0,44 |
| L9852 | 39 | 19,4 | 0,59 |
| L9852 | 61 | 26,1 | 0,80 |

In particular, the mean (average) values for the residual strain are significantly lower than the values of 2.5 × 10⁻⁶ or more known from prior art. These values also emphasize that the wafers are suitable for enabling step-free post-epitaxial surfaces on wafers even within their edge areas up to an edge exclusion of 1 mm.

Residual stress measurements were carried out also for 8" GaAs wafers (diameter: 200 mm, formed from semiconducting material) according to embodiments. Table 9B below shows the mean values for the mechanical residual stresses and residual strains determined for the samples:

**Tabelle 9B:**

| Samples: Single crystal (8" GaAs) | Samples: Wafer # | Residual Stress average or mean value [kPa] | Residual Strain: average or mean value [10⁻⁶] |
|---|---|---|---|
| P6883 | 1 | 53,7 | 1,64 |
| P6883 | 58 | 32,7 | 1,00 |
| P6862 | 2 | 36,1 | 1,10 |
| P6862 | 90 | 55,6 | 1,70 |

The results may still be considered being advantagous andreasonable.

Fig. 11 shows for a wafer sample (6"-GaAs wafer - diameter: 150 mm, made of semi-insulating material (value ranges for the specific electrical resistance, e.g. 10⁷ - 10⁹ Ωcm, in particular 1·10⁸ Ωcm - 8·10⁸ Ωcm) a profile of values determined in COREMA measurements for the specific electrical resistance across the surface of the wafer. As described, wafers with 1 mm oversize and no edge rounding were to be measured. The dashed line shows the corresponding measurement with edge rounding and without oversize for comparison. The measured values at the very edge show extremely strong, unrepresentative deflections that do not allow any statement to be made about the actual conditions regarding the specific electrical resistance in the edge area of the samples, which is why the measurement was carried out with oversize of the wafer and is a better representation.

An evaluation of the profiles to determine the homogeneity of the distribution of the resistance showed (see equations (4) to (8) above) that the global standard deviation, e.g., for sample in Fig. 11, was less than 4 % in relation to a entire wafer surface with edge exclusion of only 1 mm, namely: ${σ}_{ρ} total = 5 , 23 %$ ${σ}_{ρ} global = 3 , 51 %$ ${σ}_{ρ} local = 3 , 61 %$

The values for the same wafer sample having an edge exclusion of 3 mm are as follows: ${σ}_{ρ} total = 5 , 07 %$ ${σ}_{ρ} global = 3 , 39 %$ ${σ}_{ρ} local = 3 , 55 % ,$ whereas the annular edge area defined by a distance of 1 to 3 mm from the wafer edge (i.e. edge exclusion 1 mm) itself and taken alone provided a global standard deviation of 31.65 %.

Corresponding values for conventionally manufactured 6" GaAs VGF wafers are described in the above-mentioned publication DE 10 2007 026 298 A1 or WO 2008/148542 A1 (or US 8,652,253 B1), whereby only the edge exclusion of 3 mm, which was of interest at that time, was taken into account hereby:

### Example 1:

${σ}_{ρ} total = 6 , 5 %$ ${σ}_{ρ} global = 5 , 3 %$ ${σ}_{ρ} local = 2 , 5 % ,$

### Example 2:

${σ}_{ρ} total = 4 , 5 %$ ${σ}_{ρ} global = 2 , 8 %$ ${σ}_{ρ} local = 1 , 25 %$

Because the global standard deviation for the specific electrical resistance with regard to the edge area covering a distanc range of 1 - 3 mm towards the wafer edge allows to expect even comparatively higher values, as in the above embodiment, the values of 5.3 % and 4.5 % according to the comparative examples will increase significantly if an edge exclusion of only 1 mm is taken into account.

The values obtained for the present embodiment are therefore also very low, especially when taking into account the now narrower edge exclusion compared to prior art.

In view of the positive results for the 6" GaAs wafer, COREMA measurements were also carried out for 8" GaAs wafers (diameter: 200 mm, made of semi-insulating material, value ranges for the specific electrical resistance, e.g. 10⁷ - 10⁹ Ωcm, in particular 1·10⁸ Ωcm - 8·10⁸ Ωcm) in accordance with embodiments of the present invention. As the wafers were too large in diameter to be accommodated in the measuring device before edge rounding, the wafer was divided into exactly four parts and these were measured individually. An evaluation of the measurement data in relation to a complete (entire) wafer surface with edge exclusion of only 1 mm resulted in the following values:

**Table 10**

| | Complete surface, 1 mm edge exclusion | | |
|---|---|---|---|
| Wafer | σ_{ρ} total | σ_{ρ} global | σ_{ρ} local |
| P0790_24 | 12.42% | 10.13% | 6.95% |
| Q2250_02 | 10.51% | 5.6% | 8.57% |
| Q2250_46 | 13.85% | 10.85% | 8.35% |
| Q2250_93 | 17.30% | 15.15% | 8.20% |

An evaluation of the measurement data of the same embodiments with reference to the edge area only, with a distance range of 1 to 3 mm to the wafer edge (i.e., edge exclusion 1 mm), provided the following values:

**Table 11**

| | Edge area with distance 1 to 3 mm to wafer edge | | |
|---|---|---|---|
| Wafer | σ_{ρ} total | σ_{ρ} global | σ_{ρ} local |
| P0790_24 | 13.09% | 8.2% | 9.84% |
| Q2250_02 | 10.61% | 6.84% | 7.75% |
| Q2250_46 | 14.49% | 9.59% | 10.67% |
| Q2250_93 | 17.39% | 14.04% | 9.79% |

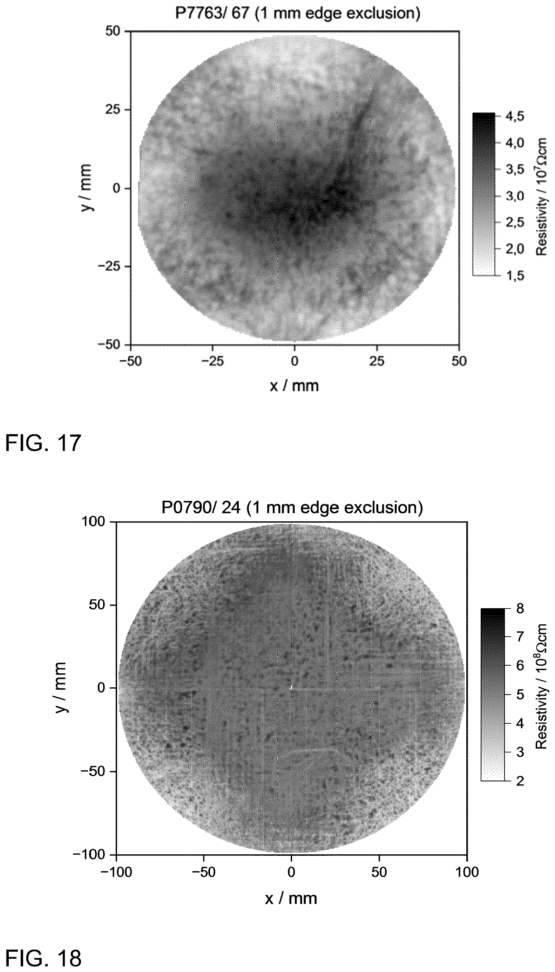

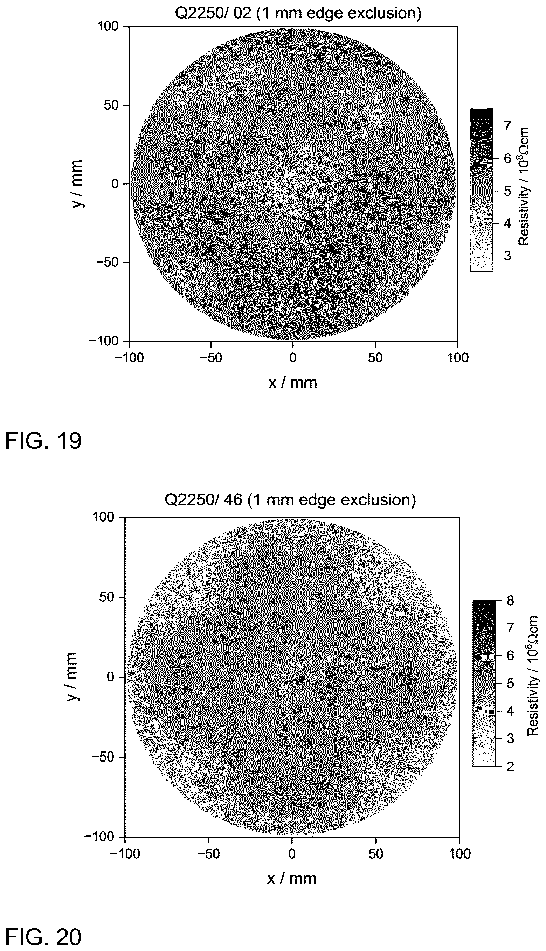

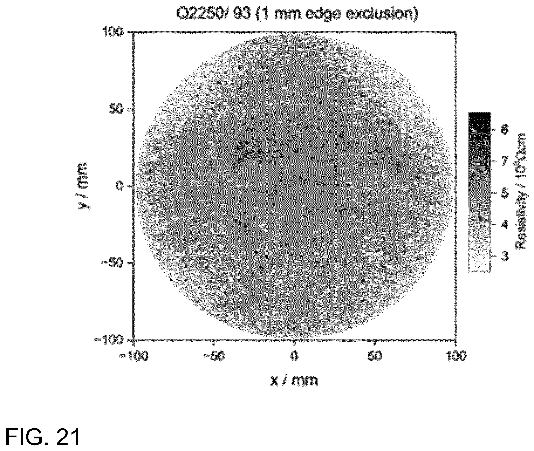

The topogram for wafer P0790_24 is depicted in Fig. 18, the topogram for wafer Q2250_02 in Fig. 19, the topogram for wafer Q2250_46 in Fig. 20 and the topogram for wafer Q2250_93 in Fig. 21.

COREMA measurements were also carried out for four 4"-InP wafers (diameter: 100 mm, made of semi-insulating material, resistivity 0.8·10⁸ Ωcm - 4·10⁸ Ωcm) according to embodiments before edge rounding. An evaluation of the measurement data related to a complete (entire) wafer surface with edge exclusion of only 1 mm resulted in the following values:

**Table 12:**

| | Complete surface, 1 mm edge exclusion | | |
|---|---|---|---|
| Wafer | σ_{ρ} total | σ_{ρ} global | σ_{ρ} local |
| P4491_40 | 11.99% | 13.78% | 3.65% |
| P7763_1 | 10.73% | 9.02% | 3.51% |
| P7763_33 | 12.21% | 8.42% | 6.77% |
| P7763_67 | 18.28% | 16.21% | 5.69% |

An evaluation of the measurement data of the same wafer samples with reference to the edge area only, with a distance range of 1 to 3 mm to the wafer edge (i.e., edge exclusion 1 mm), provided the following values:

**Table 13:**

| | Edge area with distance 1 to 3 mm to wafer edge | | |
|---|---|---|---|
| Wafer | σ_{ρ} total | σ_{ρ} global | σ_{ρ} local |
| P4491_40 | 9.84 | 11.73 | 3.43 |
| P7763_1 | 11.48 | 4.72 | 2.31 |
| P7763_33 | 5.88 | 4.9 | 2.87 |
| P7763_67 | 11.60 | 9.18 | 5.48 |

The topogram for wafer P7763_33 is shown in Fig. 16 and the topogram for wafer 7763_67 in Fig. 17.

## Claims

1. Device (1) for manufacturing an AIII-BV - compound semiconductor single crystal (4) from a melt (5) of a raw material, the device (1) configured to be operated according to Vertical Gradient Freeze (VGF) or the Vertical Bridgman (VB) method, comprising:
a crucible (6) for receiving a melt, wherein the crucible (7) has a seed channel (3), a central axis (M) and a crucible wall (7) having a shell-shaped outer face, which faces away from the central axis (M) in a direction radially outwards;
a component (10) substantially surrounding the crucible (6) and opposing the crucible wall (7) in a distance by an inner face facing the outer face, wherein the crucible wall (7) is provided in a relationship with the component (10) surrounding the crucible (6) that is substantially a thermal radiation exchange;
wherein the outer face of the crucible wall (7) has first emissivity (ε₁) and the inner face of the opposite component (10) surrounding the crucible (6) has a second emissivity (ε₂), wherein the first emissivity and second emissivity (ε₁, ε₂) indicate how much radiation is emitted from the crucible wall (7) and the component (10) surrounding the crucible, respectively, as compared with an ideal radiant heater,
wherein the outer face of the crucible wall (7) and the inner face of the component (10) surrounding the crucible are at least partially provided each by a coating (8a, 8b) which define the first emissivity (ε₁) and the second emissivity (ε₂), respectively, such that the first emissivity and/or the second emissivity each amount to a value of 0.1 or less, respectively.

2. Device (1) according to claim 1, wherein the first emissivity (ε₁) as well as the second emissivity (ε2) amount to a value of 0.1 or less.

3. Device (1) according to claim 1 or 2, wherein the first emissivity (ε₁) as well as the second emissivity (ε₂) amount to a value of 0.05 or less.

4. Device (1) according to one of claims 1 to 3, wherein a radiation exchange degree in the radiation exchange between the crucible wall (7) and the component (10) surrounding the crucible amounts to 0.1 or less.

5. Device (1) according to one of claims 1 to 4, wherein
the outer face of the crucible wall (7) and the inner face of the opposing component (10) jointly form and limit an intermediate space (8) shaped as a cylindrical shell, across which radiation exchange occurs during operation of the device.

6. Device (1) according to one of claims 1 to 5, wherein
the coating (8a, 8b), which at least partially forms the outer face and/or the inner face, is provided as a periodic pattern, in particular as a mosaic- or strip-like pattern.

7. Device (1) according to one of claims 1 to 6, wherein
the coating (8a, 8b), which at least partially forms the outer face and/or the inner face, is prepared as shiny metallic.

8. Device (1) according to one of claims 1 to 6, wherein
the component (10) surrounding the crucible is manufactured from hard graphite and includes:
- a rough metallic layer; or
- a shiny metallic layer.

9. Device (1) according to one of claims 1 to 6, wherein
the component (10) surrounding the crucible is a quartz tube coated with graphite.

10. Device (1) according to claim 9, wherein
the component (10) surrounding the crucible is a liner.

11. Device (1) according to one of claims 1 to 10, wherein
the crucible (6) is made of boron nitride or pyrolytic boron nitride, wherein the outer face of the crucible wall (7) is at least partially formed by
- a rough platinum or graphite coating; or
- a shiny platinum or graphite coating.

12. Device according to one of claims 1 to 10, wherein
the crucible (6) is formed from glassy-carbon.

13. Device (1) according to one of claims 1 to 12, further comprising:
one or more heating elements, which are arranged outside of the component (10) which opposes the crucible (6) when viewed from the central axis (M) of the crucible (6).

14. Device (1) according to one of claims 1 to 13, wherein
the device (1) is configured to manufacture an AIII-BV-compound semiconductor single crystal comprising GaAs or InP, preferably for separation into wafers having nominal diameters of 100 mm, 150 mm or 200 mm.

15. Device (1) according to one of claims 1 to 14, wherein
the crucible wall (7) is formed from a material having an inner structure, such that heat conductions is isotropic.

16. Device (1) according to one of claims 1 to 15, wherein
the crucible wall (7) is formed from a material having an inner structure, such that heat conductions amounts to 3 W/mK or less.

17. Method of manufacturing a AIII-BV-compound semiconductor single crystal from a melt of a raw material, comprising:
providing a device according to one of the preceding claims 1 - 16; inserting a seed crystal into the seed channel;
setting a directed temperature field parallel to the central axis of the crucible by means of one or more heating elements;
adjusting a crystal growth rate by controlling the one or more heating elements such that an inclination angle of 40 degrees or less, preferably 37 degrees or less in case of GaAs as an AIII-BV-compound semiconductor or 34 degrees or less in case of InP as an AIII-BV- compound semiconductor, more preferably 32 degrees or less in case of GaAs as an AIII-BV-compound semiconductor or 31 degrees or less in case of InP as an AIII-BV-compound semiconductor between a phase boundary and a horizontal direction perpendicular to an inner surface of an adjacent lateral crucible wall is continuously maintained;
crystallizing and further cooling of the single crystal.

18. Method according to claim 17, wherein
the growth rate amounts to 2 mm/h or less.

## Patentansprüche

1. Vorrichtung (1) zur Herstellung eines AIII-BV-Verbindungshalbleiter-Einkristalls (4) aus der Schmelze (5) eines Rohmaterials, wobei die Vorrichtung (1) eingerichtet ist, gemäß einem Vertical Gradient Freeze (VGF) Verfahren oder einem Vertical Bridgman (VB) Verfahren betrieben zu werden, umfassend:
einen Tiegel (6) zur Aufnahme der Schmelze, wobei der Tiegel (7) einen Keimkanal (3), eine Mittenachse (M) und eine Tiegelwand (7) mit einer mantelförmigen Außenoberfläche aufweist, die von der Mittenachse (M) weg in eine radiale Richtung nach außen weist;
ein den Tiegel (6) im Wesentlichen umgebendes, und der Tiegelwand (7) in einem Abstand gegenüberstehendes Bauteil (10) mit einer der Außenoberfläche zugewandten Innenoberfläche, wobei die Tiegelwand (7) mit dem den Tiegel (6) umgebenden Bauteil (10) in einer Beziehung im Wesentlichen thermischen Strahlungsaustausches steht;
wobei die Außenoberfläche der Tiegelwand (7) eine erste Emissivität (ε₁) und die Innenoberfläche des ihr gegenüberstehenden, den Tiegel (6) umgebenden Bauteils (10) eine zweite Emissivität (ε₂) aufweist, wobei die erste und die zweite Emissivität (ε₁, ε₂) angeben, wieviel Strahlung die Tiegelwand (7) bzw. das den Tiegel umgebende Bauteil (10) im Vergleich zu einem idealen Wärmestrahler abgeben,
wobei die Außenoberfläche der Tiegelwand (7) und die Innenoberfläche des den Tiegel umgebenden Bauteils (10) zumindest teilweise durch eine die erste bzw. zweite Emissivität bestimmende Beschichtung (8a, 8b) gebildet werden, so dass die erste Emissivität (ε₁) und/oder die zweite Emissivität (ε₂) einen Wert 0,1 oder weniger beträgt.

2. Vorrichtung (1) gemäß Anspruch 1, wobei sowohl die erste Emissivität (ε₁) als auch die zweite Emissivität (ε₂) einen Wert von 0,1 oder weniger betragen.

3. Vorrichtung (1) gemäß Anspruch 1 oder 2, wobei die erste (ε₁) und/oder die zweite Emissivität (ε₂) einen Wert von 0,05 oder weniger beträgt.

4. Vorrichtung (1) gemäß einem der Ansprüche 1 bis 3, wobei ein Strahlungsaustauschgrad bei dem Strahlungsaustausch zwischen der Tiegelwand (7) und dem den Tiegel umgebenden Bauteil (10) 0,1 oder weniger beträgt.

5. Vorrichtung (1) gemäß einem der Ansprüche 1 bis 4, wobei
die Außenoberfläche der Tiegelwand (7) und die Innenoberfläche des ihr gegenüberliegenden Bauteils (10) einen zylindermantelförmigen Zwischenraum (8) ausbilden und im Wesentlichen begrenzen, über welchen hinweg im Betrieb der Strahlungsaustausch stattfindet.

6. Vorrichtung (1) gemäß einem der Ansprüche 1 bis 5, wobei
die die Außenoberfläche und/oder die Innenoberfläche zumindest teilweise ausbildende Beschichtung (8a, 8b) als ein periodisches Muster, insbesondere ein mosaik- oder streifenartiges Muster ausgebildet ist.

7. Vorrichtung (1) gemäß einem der Ansprüche 1 bis 6, wobei
die die Außenoberfläche und/oder die Innenoberfläche zumindest teilweise ausbildende Beschichtung (8a, 8b) metallisch glänzend präpariert ist.

8. Vorrichtung (1) gemäß einem der Ansprüche 1 bis 6, wobei
das den Tiegel umgebende Bauteil (10) aus Hartgraphit gefertigt ist und aufweist:
- eine rauhe Metallschicht; oder
- eine glänzende Metallschicht.

9. Vorrichtung gemäß einem der Ansprüche 1 bis 6, wobei
das den Tiegel umgebende Bauteil (10) ein mit Graphit beschichtetes Quarzrohr ist.

10. Vorrichtung (1) gemäß Anspruch 9, wobei
das den Tiegel umgebende Bauteil (10) ein Liner ist.

11. Vorrichtung (1) gemäß einem der Ansprüche 1 bis 10, wobei
der Tiegel (6) aus Bornitrid oder pyrolytischem Bornitrid gefertigt ist, wobei die Außenoberfläche der Tiegelwand (7) zumindest teilweise durch
- eine rauhe Platin- oder Graphit-Beschichtung ausgebildet wird; oder
- eine glänzende Platin- oder Graphit-Beschichtung
gebildet wird.

12. Vorrichtung (1) gemäß einem der Ansprüche 1 bis 10, wobei
der Tiegel (6) aus Glaskohlenstoff gefertigt ist.

13. Vorrichtung (1) gemäß einem der Ansprüche 1 bis 12, ferner umfassend:
ein oder mehrere Heizelemente, die von der Mittenachse (M) des Tiegels (6) aus gesehen außerhalb des gegenüberliegenden Bauteils (10) angeordnet sind.

14. Vorrichtung (1) gemäß einem der Ansprüche 1 bis 13, wobei
die Vorrichtung (1) eingerichtet ist, einen AIII-BV-Verbindungshalbleiter-Einkristall umfassend GaAs oder InP, vorzugsweise zur Vereinzelung in Wafer mit Nenndurchmessern von 100 mm, 150 mm oder 200 mm herzustellen.

15. Vorrichtung (1) gemäß einem der Ansprüche 1 bis 14, wobei
die Tiegelwand (7) aus einem Material mit einem inneren Aufbau derart gebildet ist, dass die Wärmeleitung isotrop ist.

16. Vorrichtung gemäß einem der Ansprüche 1 bis 15, wobei
die Tiegelwand (7) aus einem Material mit einem inneren Aufbau derart gebildet ist, dass die Wärmeleitung 3 W/mK oder weniger beträgt.

17. Verfahren zur Herstellung eines AIII-BV-Verbindungshalbleiter-Einkristalls aus der Schmelze eines Rohmaterials, umfassend:
Bereitstellen der Vorrichtung nach einem der vorhergehenden Ansprüche 1 - 16;
Bestücken des Keimkanals mit einem Kristallkeim;
Einstellen eines gerichteten Temperaturfelds parallel zur Mittenachse des Tiegels mittels eines oder mehrere Heizelemente;
Einstellen einer Kristallisationsgeschwindigkeit durch Steuern des Heizelements bzw. der Heizelemente derart, dass sich fortlaufend ein Neigungswinkel von 40 Grad oder weniger, vorzugsweise 37 Grad oder weniger im Fall von GaAs als AIII-BV-Verbindungshalbleiter oder 34 Grad oder weniger im Fall von InP als AIII-BV-Verbindungshalbleiter, weiter bevorzugt 32 Grad oder weniger im Fall von GaAs als AIII-BV-Verbindungshalbleiter oder 31 Grad oder weniger im Fall von InP als, AIII-BV-Verbindungshalbleiter, zwischen einer Phasengrenzfläche und einer horizontalen Richtung senkrecht zu einer Innenoberfläche einer angrenzenden Tiegelwand einstellt;
Erstarren und weiteres Abkühlen des Einkristalls.

18. Verfahren gemäß Anspruch 19, wobei
die Kristallisationsgeschwindigkeit 2 mm/h oder weniger beträgt.

## Revendications

1. Dispositif (1) de fabrication d'un monocristal semi-conducteur composite AIII-BV (4) à partir d'une masse fondue (5) d'une matière première, le dispositif (1) étant configuré pour fonctionner selon le procédé Vertical Gradient Freeze (VGF) ou le procédé Vertical Bridgman (VB), comprenant :
un creuset (6) pour recevoir une masse fondue, où le creuset (7) a un canal d'ensemencement (3), un axe central (M) et une paroi de creuset (7) ayant une face externe en forme de coque, qui est orientée à l'opposé de l'axe central (M) dans une direction radialement vers l'extérieur ;
un composant (10) entourant sensiblement le creuset (6) et opposé à la paroi de creuset (7) dans une distance par une face interne faisant face à la face externe, où la paroi de creuset (7) est prévue dans une relation avec le composant (10) entourant le creuset (6) qui est sensiblement un échange de rayonnement thermique ;
où la face externe de la paroi de creuset (7) a une première émissivité (ε₁) et la face interne du composant opposé (10) entourant le creuset (6) a une seconde émissivité (ε₂), où la première émissivité et la seconde émissivité (ε_{1,} ε₂) indiquent combien de rayonnement est émis à partir de la paroi de creuset (7) et du composant (10) entourant le creuset, respectivement, par rapport à un radiateur idéal,
où la face externe de la paroi de creuset (7) et la face interne du composant (10) entourant le creuset sont au moins partiellement fournies chacune par un revêtement (8a, 8b) qui définissent la première émissivité (ε₁) et la seconde émissivité (ε₂), respectivement, de sorte que la première émissivité et/ou la seconde émissivité s'élèvent chacune à une valeur de 0,1 ou moins, respectivement.

2. Dispositif (1) selon la revendication 1, où la première émissivité (ε₁) ainsi que la seconde émissivité (ε₂) s'élèvent à une valeur de 0,1 ou moins.

3. Dispositif (1) selon la revendication 1 ou 2, où la première émissivité (ε₁) ainsi que la seconde émissivité (ε₂) s'élèvent à une valeur de 0,05 ou moins.

4. Dispositif (1) selon l'une des revendications 1 à 3, où un degré d'échange de rayonnement dans l'échange de rayonnement entre la paroi de creuset (7) et le composant (10) entourant le creuset s'èlève à 0,1 ou moins.

5. Dispositif (1) selon l'une des revendications 1 à 4, où
la face externe de la paroi de creuset (7) et la face interne du composant opposé (10) forment et délimitent conjointement un espace intermédiaire (8) en forme de coque cylindrique, à travers lequel un échange de rayonnement se produit pendant le fonctionnement du dispositif.

6. Dispositif (1) selon l'une des revendications 1 à 5, où
le revêtement (8a, 8b), qui forme au moins partiellement la face externe et/ou la face interne, est prévu comme un motif périodique, en particulier comme un motif en forme de mosaïque ou de bande.

7. Dispositif (1) selon l'une des revendications 1 à 6, où
le revêtement (8a, 8b), qui forme au moins partiellement la face externe et/ou la face interne, est préparé comme un métal brillant.

8. Dispositif (1) selon l'une des revendications 1 à 6, où
le composant (10) entourant le creuset est fabriqué à partir de graphite dur et comprend :
- une couche métallique rugueuse ; ou
- une couche métallique brillante.

9. Dispositif (1) selon l'une des revendications 1 à 6, où
le composant (10) entourant le creuset est un tube de quartz revêtu de graphite.

10. Dispositif (1) selon la revendication 9, où
le composant (10) entourant le creuset est une chemise.

11. Dispositif (1) selon l'une des revendications 1 à 10, où
le creuset (6) est fait de nitrure de bore ou de nitrure de bore pyrolytique, où la face externe de la paroi de creuset (7) est au moins partiellement formée par
- un revêtement de platine ou de graphite rugueux ; ou
- un revêtement de platine ou de graphite brillant.

12. Dispositif selon l'une des revendications 1 à 10, où
le creuset (6) est formé en carbone vitreux.

13. Dispositif (1) selon l'une des revendications 1 à 12, comprenant en outre :
un ou plusieurs éléments chauffants, qui sont disposés à l'extérieur du composant (10) qui est opposé au creuset (6) vu depuis l'axe central (M) du creuset (6).

14. Dispositif (1) selon l'une des revendications 1 à 13, où
le dispositif (1) est configuré pour fabriquer un monocristal semi-conducteur composite AIII-BV comprenant du GaAs ou de l'InP, de préférence pour la séparation en tranches ayant des diamètres nominaux de 100 mm, 150 mm ou 200 mm.

15. Dispositif (1) selon l'une des revendications 1 à 14, où
la paroi de creuset (7) est formée en un matériau ayant une structure interne telle que la conduction de chaleur est isotrope.

16. Dispositif (1) selon l'une des revendications 1 à 15, où
la paroi de creuset (7) est formée en un matériau ayant une structure interne telle que la conduction de chaleur est de 3 W/mK ou moins.

17. Procédé de fabrication d'un monocristal semi-conducteur composite AIII-BV à partir d'une masse fondue d'une matière première, comprenant :
la fourniture d'un dispositif selon l'une des revendications précédentes 1 à 16 ;
l'insertion d'un cristal d'ensemencement dans le canal d'ensemencement ;
le réglage d'un champ de température dirigé parallèlement à l'axe central du creuset au moyen d'un ou plusieurs éléments chauffants ;
l'ajustement d'un taux de croissance de cristal en commandant les un ou plusieurs éléments chauffants de telle sorte qu'un angle d'inclinaison de 40 degrés ou moins, de préférence de 37 degrés ou moins dans le cas de GaAs en tant que semi-conducteur composite AIII-BV ou de 34 degrés ou moins dans le cas d'InP en tant que semi-conducteur composite AIII-BV, plus préférablement de 32 degrés ou moins dans le cas de GaAs en tant que semi-conducteur composite AIII-BV ou de 31 degrés ou moins dans le cas d'InP en tant que semi-conducteur composite AIII-BV entre une limite de phase et une direction horizontale perpendiculaire à une surface interne d'une paroi de creuset latérale adjacente est maintenu en continu ;
la cristallisation et le refroidissement supplémentaire du monocristal.

18. Procédé selon la revendication 17, où
le taux de croissance s'élève à 2 mm/h ou moins.
